# EUROPEAN PATENT SPECIFICATION

(11) **EP 3 721 303 B1**
(45) Date of publication and mention of the grant of the patent: **15.02.2023**
(21) Application number: 18839548.7
(22) Date of filing: 28.12.2018
(51) Int. Cl.: G05B 17/02, G05B 19/418, G06F 30/20

(54) **SIMULATION APPARATUS, SYSTEM, METHOD AND PROGRAM**
SIMULATIONSVORRICHTUNG, SYSTEM, VERFAHREN UND PROGRAMM
APPAREIL, SYSTÈME, PROCÉDÉ ET PROGRAMME DE SIMULATION

(30) Priority: 28.12.2017 JP 2017254865
(43) Date of publication of application: 14.10.2020
(73) Proprietor: YOKOGAWA ELECTRIC CORPORATION, Musashino-shi Tokyo 180-8750 (JP)
(72) Inventor: KIMURA, Yuuri, Musashino-shi, Tokyo 180-8750 (JP); SEKI, Tatenobu, Musashino-shi, Tokyo 180-8750 (JP); EMA, Nobuaki, Musashino-shi, Tokyo 180-8750 (JP)
(74) Representative: Winter, Brandl - Partnerschaft mbB
(86) International application number: PCT/JP2018/048587
(87) International publication number: WO 2019/132035

(56) References cited:
- EP-A1- 3 203 338
- WO-A1-97/42553
- US-A1- 2015 106 075

## Description

The present invention relates to an apparatus, a simulation system, a method and a program.

Conventionally, for a plant and the like, a design, a performance evaluation, an operator training and the like have been performed using a plurality of pieces of software before completion of an actual plant. For example, software, such as a static simulator to simulate a steady state and the like of the plant, plant engineering software to create a piping and instrumentation diagram and the like of the plant, and a dynamic simulator to simulate a dynamic behavior and the like of the plant, has been used (see JP 2017-138 919 A, for example).

WO 97/42553 A1 describes a method for providing independent static and dynamic models in a prediction, control and optimization environment utilizes an independent static model (20) and an independent dynamic model (22). The static model (20) is a rigorous predictive model that is trained over a wide range of data, whereas the dynamic model (22) is trained over a narrow range of data.

The gain K of the static model (20) is utilized to scale the gain k of the dynamic model (22). The forced dynamic portion of the model (22) referred to as the bi variables are scaled by the ratio of the gains K and k. The bi have a direct effect on the gain of a dynamic model (22). This is facilitated by a coefficient modification block (40). Thereafter, the difference between the new value input to the static model (20) and the prior steady-state value is utilized as an input to the dynamic model (22). The predicted dynamic output is then summed with the previous steady-state value to provide a predicted value Y. Additionally, the path that is traversed between steady-state value changes.

EP 3203338 A1 describes a plant performance evaluation apparatus includes a first storage storing a first static model indicating a model of a first steady state in a plant, a second storage storing a first dynamic model indicating a model of a dynamic state of the plant, a model converter configured to convert the first dynamic model to a second static model indicating a model of a second steady state of the plant, and to store the second static model into the first storage, the first steady state indicating a steady state of the plant temporally before the second steady state, a comparator configured to compare parameters included in the first static model with parameters included in the second static model and to output a comparison result, and a display configured to display the comparison result output from the comparator.

US 2015/0106075 A1 describes a system simulates a process entity. Software instructions stored on a memory device and executable by a processor creates an entity type object that generically represents a type of process entity. Instructions create a simulation representing a process and instantiate an entity type instance in the simulation based on the entity type object. The entity type instance represents a specific process entity in the process. Additionally, instructions simulate the functionality of the specific process entity by the entity type instance in the simulation.

US 2006/190105 A1 discloses conversion of static models to dynamic ones and generation of initial conditions.

For example, in a case in which a parameter or the like of a plant is to be determined according to a simulation by a dynamic simulator, an operation and an adjustment of the plant on the dynamic simulator may be performed to correspond to a calculation result of a static simulator. In this case, it may be difficult to perform a simulation work if the operator to operate the plant is not a skilled operator who is conversant with the operation and the like of the plant. In addition, processing time itself of the simulation gets longer as a scale of the plant is large, and the designing and the like of the plant have required a lot of labor and time.

According to the present invention, an apparatus and a method for generating a dynamic model and a dynamic simulation result to determine a specification for at least one of a design of a plant, devices in the plant, and a sizing of the plant, and/or to check a dynamic behavior of the plant and a program as defined in claims 1, 8, 9 and 10, respectively, are provided. Advantageous further developments of the invention are subject of the accompanying dependent claims.

In a first aspect of the present invention, an apparatus is provided for generating a dynamic model and a dynamic simulation result to determine a specification for at least one of a design of a plant, devices in the plant, and a sizing of the plant, and/or to check a dynamic behavior of the plant, the apparatus (100), comprising:
a static model acquiring unit (110) configured to acquire a static model (22);
a storage unit (120) configured to store the static model (22);
a result acquiring unit (140) configured to acquire a simulation result of the static model (22) indicating a first steady state of the plant;
an initial state generating unit (150) configured to generate, based on the simulation result, a first initial value of a state parameter of a dynamic model (42) that is a model calculating a dynamic state of the plant; and
a dynamic plant simulator configured to provide the dynamic simulation result (44) of the plant based on the dynamic model (42),
characterized in that
the initial state generating unit (150) is further configured
to convert one of a unit, a physical amount, and a variable of a state parameter value of at least one device of the plant included in the static model (22) into the first initial value of the state parameter of at least one corresponding device in the dynamic model (42) that respectively corresponds to the at least one device included in the static model (22),
the state parameter value being calculated by a simulation using the static model (22).

In a second aspect of the present invention, using a simulation result, a dynamic model and a dynamic simulation result in a simulation system (200) to determine a specification for at least one of a design of a plant, devices in the plant, and a sizing of the plant, and/or to check a dynamic behavior of the plant, the simulation system (200) comprises:
the apparatus (100) according to any one of claims 1 to 5;
a static simulator (20) configured to perform a static simulation to generate the static model (22); and
a dynamic simulator (40) configured to perform a dynamic simulation by setting the state parameter of the dynamic model (42) as the initial value and using the dynamic model (42).

In a third aspect of the present invention, a method is provided for generating a dynamic model and a dynamic simulation result to determine a specification for at least one of a design of a plant, devices in the plant, and a sizing of the plant, and/or to check a dynamic behavior of the plant, the method comprising:
acquiring a static model (22);
storing the static model (22);
acquiring a simulation result of the static model (22) indicating a steady state of the plant;
generating, based on the simulation result, an initial value of a state parameter of a dynamic model (42) that is a model calculating a dynamic state of the plant; and
simulating a state of the plant based on the dynamic model (42), thereby providing the dynamic simulation result,
characterized in that
the method further comprises:
   converting one of a unit, a physical amount, and a variable of a state parameter value of at least one device of the plant included in the static model (22) into the initial value of a state parameter of at least one corresponding device in the dynamic model (42) that respectively corresponds to the at least one device included in the static model (22), and
   the state parameter value being calculated by a simulation using the static model (22)

In a fourth aspect of the present invention, a program is provided. The program may make a computer serve as the apparatus of the first aspect. The program may make a computer serve as the simulation system of the second aspect.

The summary clause does not necessarily describe all necessary features of the embodiments of the present invention. The present invention may also be a sub-combination of the features described above.
[Fig. 1]

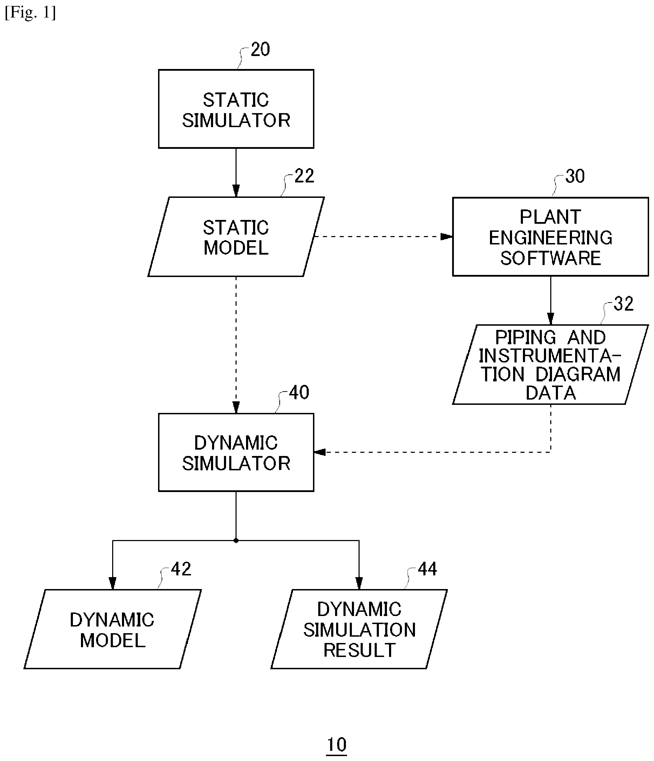

   Fig. 1 shows a configuration example of a generating apparatus 10 configured to generate a simulation model of a plant.
[Fig. 2]

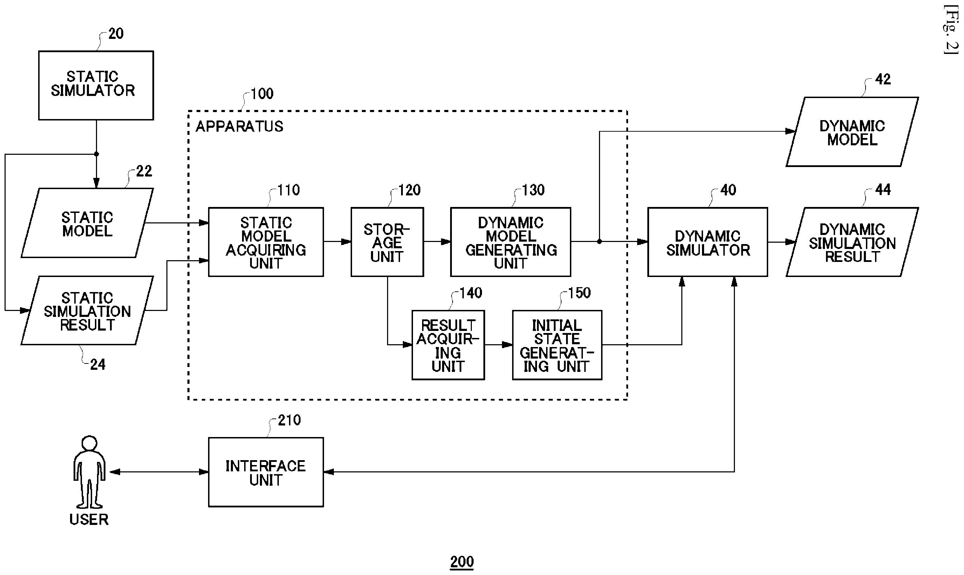

   Fig. 2 shows a configuration example of a simulation system 200 according to the present embodiment.
[Fig. 3]

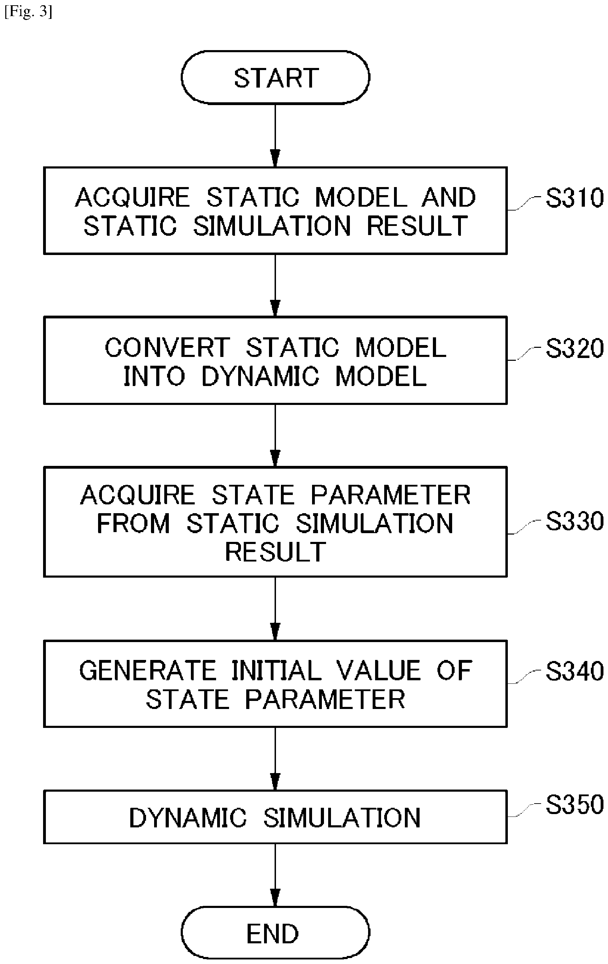

   Fig. 3 shows one example of an operation flow of the simulation system 200 according to the present embodiment.
[Fig. 4]

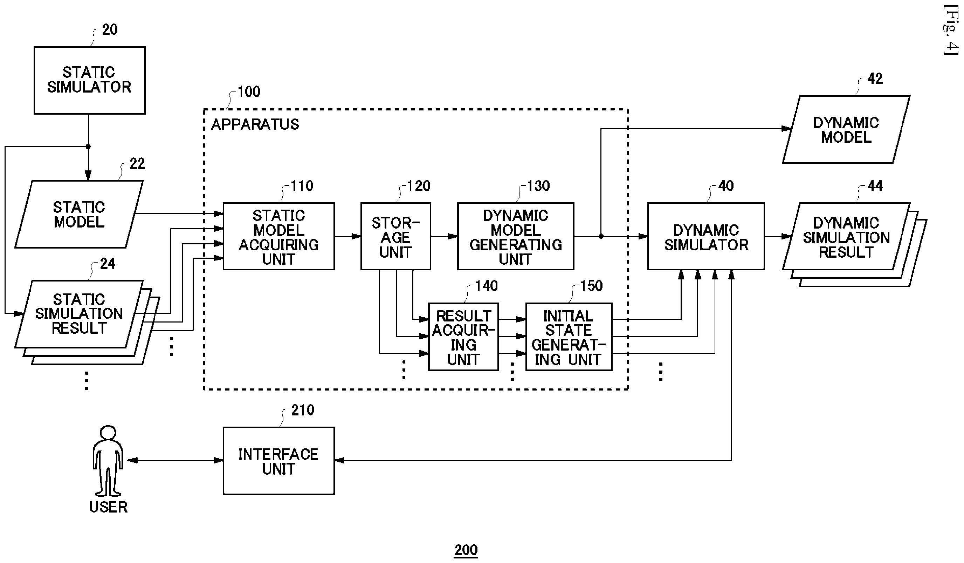

   Fig. 4 shows a first modified example of the simulation system 200 according to the present embodiment.
[Fig. 5]

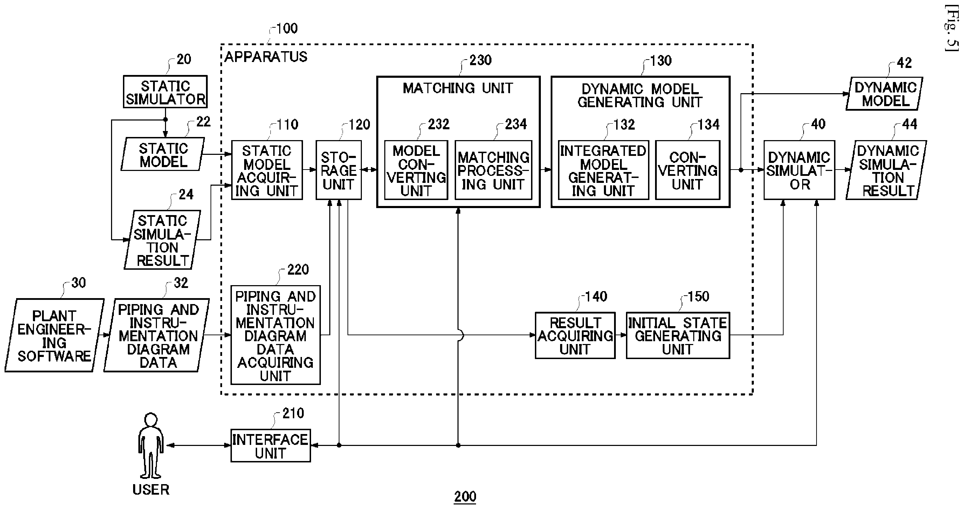

   Fig. 5 shows a second modified example of the simulation system 200 according to the present embodiment.
[Fig. 6]

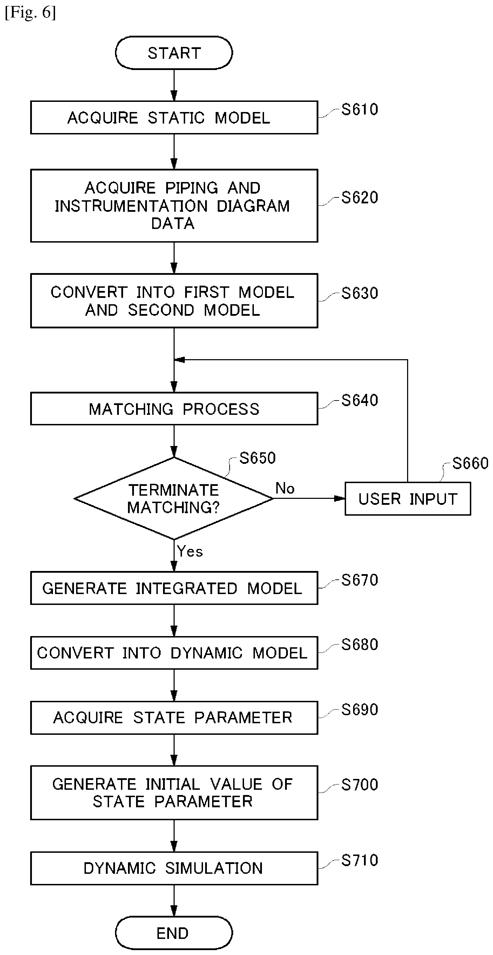

   Fig. 6 shows one example of an operation flow of the simulation system 200 of the second modified example.
[Fig. 7]

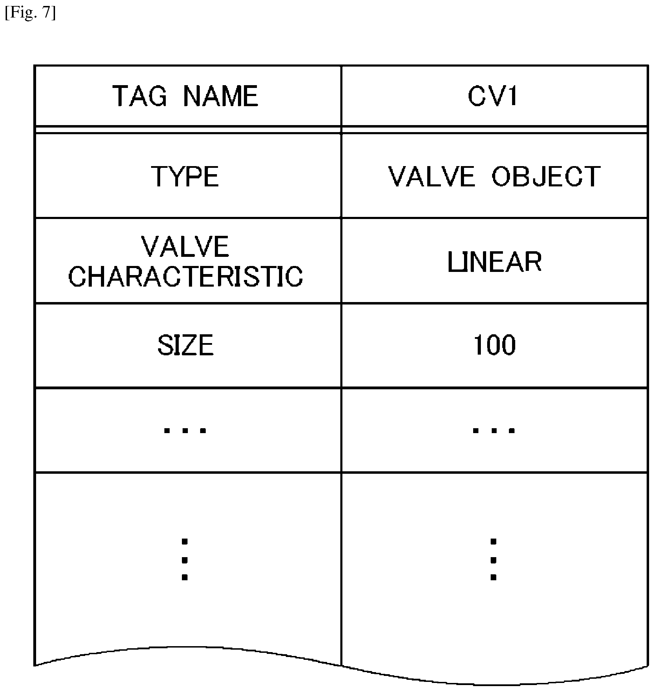

   Fig. 7 shows one example of a first model converted by a model converting unit 232 according to the present embodiment.
[Fig. 8]

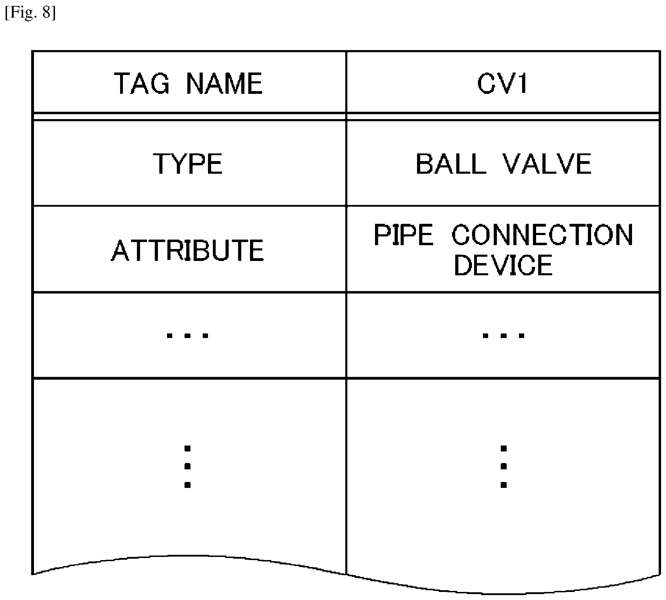

   Fig. 8 shows one example of a second model converted by the model converting unit 232 according to the present embodiment.
[Fig. 9]

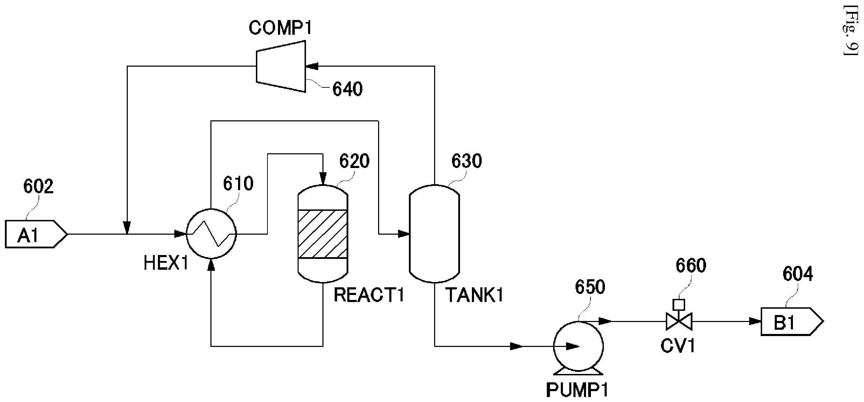

   Fig. 9 shows one example of a static model 22 according to the present embodiment.
[Fig. 10]

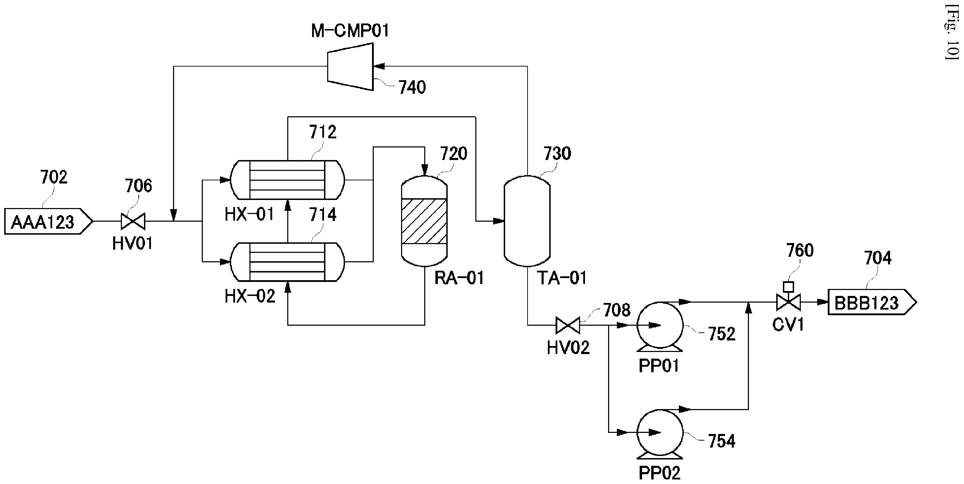

   Fig. 10 shows one example of piping and instrumentation diagram data 32 according to the present embodiment.
[Fig. 11]

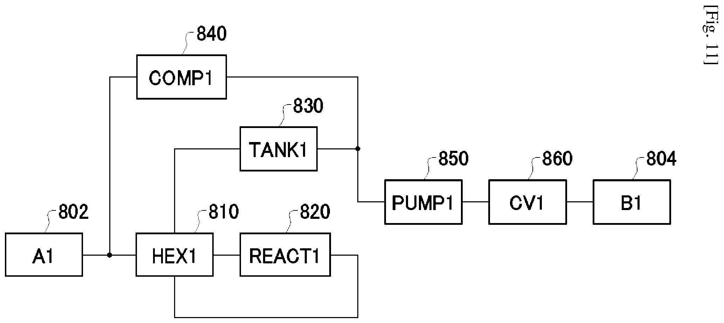

   Fig. 11 shows one example of the first model converted by the model converting unit 232, by using ontology, according to the present embodiment.
[Fig. 12]

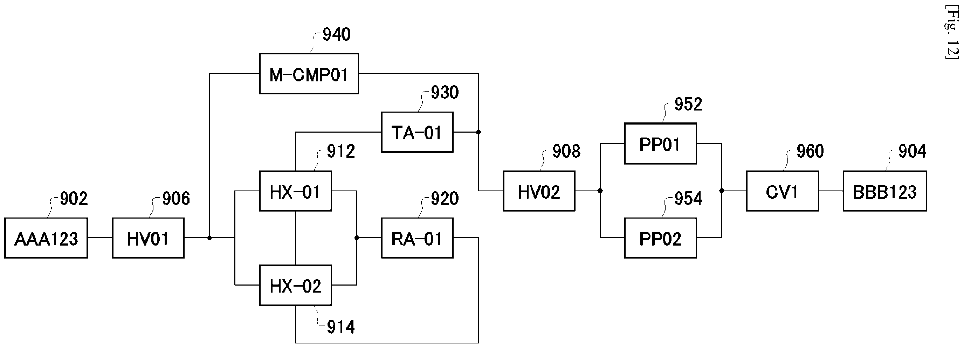

   Fig. 12 shows one example of the second model converted by the model converting unit 232, by using ontology, according to the present embodiment.
[Fig. 13]

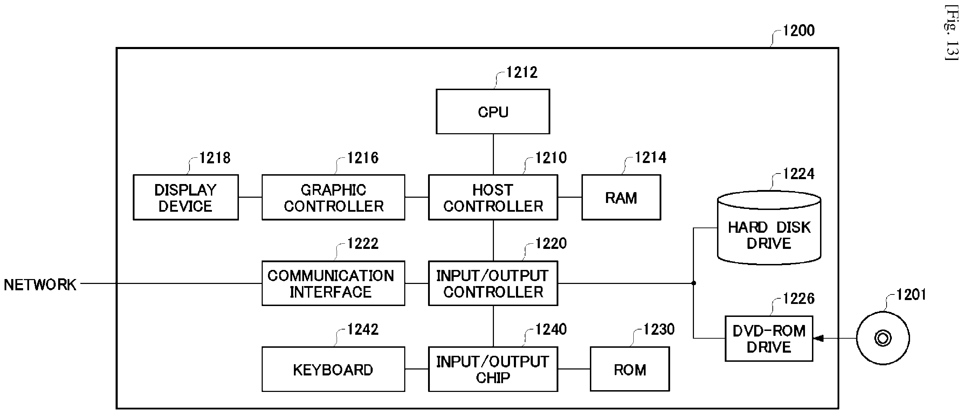

   Fig. 13 shows a configuration example of a computer 1200 in which a plurality of aspects of the present invention may be entirely or partially embodied.

Hereinafter, some embodiments of the present invention will be described.

Fig. 1 shows a configuration example of a generating apparatus 10 configured to generate a simulation model of a plant. The generating apparatus 10 generates a dynamic model of a plant to simulate a dynamic behavior and the like of the plant before completion of the plant. Here, the plant is, for example, at least a part of a factory facility, a mechanical facility, a production facility, a power-generating facility, a storage facility and the like. A simulation target may serve as at least a part of a production plant, a manufacturing plant, a chemical plant, a sludge treatment plant, a wastewater treatment plant, an air conditioning system, a thermodynamic system and the like. The generating apparatus 10 includes a static simulator 20, plant engineering software 30 and a dynamic simulator 40.

The static simulator 20 simulates a steady state of a plant. The static simulator 20 calculates a parameter or the like that a device and the like constituting the plant are to meet in a steady state under an assumed processing condition and the like, and outputs the parameter or the like as a static model 22. For example, the static simulator 20 generates and outputs the static model 22 that models ideal inputs and outputs of the plant that is in a steady operation state. Parameters included in the static model 22 include physical property information and the like of a raw material, a material, and a product. Note that the physical property information includes information and the like of a storage amount, a flow rate, a temperature, a pressure and environment such as an ambient temperature.

The static simulator 20 may generate the static model 22 based on outputs that the plant is to achieve, such as a product, a supplied substance, management quality and the like. Also, the static simulator 20 may generate the static model 22 based on a process flow diagram (PFD) and the like. For example, the static simulator 20 represents, by a plurality of parameters, inputs and outputs of each device constituting the plant, external factors such as an environment, and the like. For example, the static simulator 20 represents the plurality of parameters by simultaneous equations.

As one example, the static simulator 20 sets an input-output difference, such as a material balance of the materials, the product and the like, and a heat balance or the like, to be zero to calculate a value of each parameter in the steady state. The static simulator 20 may calculate a value of each parameter, the value temporally substantially constant. That is, the static simulator 20 may omit a time-depending parameter or the like, or may regard the parameter or the like as a substantially constant value. Also, the static simulator 20 may also calculate each parameter value substantially constant in a predetermined period. Also, the static simulator 20 may also calculate each parameter value at a predetermined time point.

The plant engineering software 30 creates a piping and instrumentation diagram (P & ID) and outputs the same, as piping and instrumentation diagram data 32. Here, the piping and instrumentation diagram data 32 is a drawing that respectively represents, with figures such as symbols and items, piping, instrumentation lines, other components and the like of the plant, for example, and specifically shows, corresponding to a to-be-realized plant, the symbols and the like by connecting the same according to their functional relations.

The piping and instrumentation diagram data 32 illustrates names of devices and piping, shapes of valves, a control system, connections between instrumentation devices and the like, and represents ultimate forms of to-be-constructed apparatuses and the like. That is, the piping and instrumentation diagram data 32 tends to have more information about a number of the devices and a connection between the devices than the information in the static model 22. Such piping and instrumentation diagram data 32 is used for a process control of the plant, a specific design of the piping system and the like. The plant engineering software 30 creates, according to a user operation using the static model 22 as a reference, the piping and instrumentation diagram data 32 corresponding to the static model 22.

The dynamic simulator 40 generates a dynamic model 42, and performs a dynamic simulation by using the generated dynamic model 42. The dynamic simulator 40 generates, by an operation of a user using the piping and instrumentation diagram data 32 as a reference, the dynamic model 42 that is a model calculating a dynamic state of the plant based on the piping and instrumentation diagram data 32. For example, the user picks up, from symbol, items and the like indicated by the piping and instrumentation diagram data 32, symbols, items and the like that affect a temporal change of the plant, arranges the picked-up ones so as to correspond to the static model 22, and generates the dynamic model 42 by the dynamic simulator 40.

Then, the dynamic simulator 40 performs computations on the dynamic model 42 represented by differential equations using a plurality of parameters, for example, based on a physical connection relation between the respective devices and an operation condition of each device. The differential equations that represent transient states show, as one example, a non-zero input-output difference in the material balance of the materials, the product and the like, the heat balance or the like, at one time point. Also, the dynamic simulator 40 calculates, by using the created dynamic model 42, the temporal change of each parameter or the like within a period from when the devices and the like constituting the plant are in a steady state until when they are in the next steady state, for example. That is, the dynamic simulator 40 calculates the temporal change of each parameter or the like by solving the differential equations representing the dynamic model 42.

The dynamic simulator 40 may determine an initial value of each parameter at a predetermined time point, the operation condition of each device and the like to calculate the temporal change of each parameter. For example, the dynamic simulator 40 may set the initial value of each parameter of the plant at an operation starting time point, and the operation condition of each device during a process from the start of the operation to the steady state to simulate the temporal change. Here, the dynamic simulator 40 may adjust the initial value and the like of each parameter based on the simulation result so that the operation of the plant in the steady state corresponds to the static model 22. That is, the dynamic simulator 40 may adjust the operation condition, the parameters and the like in the dynamic model 42 to adjust the process leading to the steady state of the plant.

Also, similarly, the dynamic simulator 40 may perform simulation from the steady state to stop of the operation of the plant. In addition, the dynamic simulator 40 may also simulate a process in which the plant transits from one steady state to another steady state. In addition, the dynamic simulator 40 may also simulate an abnormality occurrence and the like of the plant. The dynamic simulator 40 outputs such a simulation result as a dynamic simulation result 44.

As described above, the generating apparatus 10 can generate the dynamic model 42 and the dynamic simulation result 44 that can simulate the operation of the to-be-manufactured plant. Because a specification required for each device and sizing and the like of the plant can be determined based on such dynamic model 42 and dynamic simulation result 44, the generating apparatus 10 is used for the design and the like of the plant. Also, by the dynamic simulator 40, a dynamic behavior of the plant can be checked. Also, before the completion of the actual plant, an operator training can also be performed according to an operation training system and the like.

The static simulator 20, the plant engineering software 30 and the dynamic simulator 40 provided in the above-described generating apparatus 10 operate respectively separately and independently. In addition, development, upgrading and the like thereof may also be separately performed. That is, even if the plants to be simulated are the same, or the used device data and the like have common parts, there may be no compatibility between the respective pieces of software. Therefore, during a process in which the generating apparatus 10 generates the dynamic model 42, the user has to manually perform checking, setting, addition, modification, conversion and the like on the parameters, units, items and the like. For example, in Fig. 1, the arrows shown by dotted lines indicate parts for which a manual operation of a user is required.

For example, if the dynamic simulation result 44 of the plant is to be set, by the dynamic simulator, to a state of the calculation result of the static simulator, it is generally practiced to operate and adjust the plant on the dynamic simulator. In this case, it may be difficult to perform the simulation work if the operator is not a skilled operator conversant with the operation and the like of the plant. Also, if the scale of the plant to be simulated is large, a simulation processing time is long, and a time constant of the operation of the plant is large. Accordingly, the simulation processing time may further get longer. That is, working efficiency and man-hour vary depending on proficiency levels of the user to the plant and the dynamic simulator 40 and on the scale of the plant, and it may be difficult to smoothly perform the plant design.

Here, the apparatus according to the present embodiment generates a parameter indicating an operation state of the plant based on the static model 22. Accordingly, the dynamic simulator 40 outputs the dynamic simulation result 44 by using the parameter. Such an apparatus and a system using the apparatus are described next.

Fig. 2 shows a configuration example of a simulation system 200 according to the present embodiment. The simulation system 200 may generate the static model 22, and output the dynamic model 42 and the dynamic simulation result 44 based on the generated static model 22. The simulation system 200 includes the static simulator 20, the dynamic simulator 40, the apparatus 100 and the interface unit 210.

The static simulator 20 generates, by performing the static simulation, the static model 22 and a static simulation result 24 that is a simulation result of the static model 22. Because the operation of the static simulator 20 is described in Fig. 1, the description of the static simulator 20 is omitted here. Note that in Fig. 2, a result of performing, by the static simulator 20 by using the static model 22, the static simulation is explicitly shown as the static simulation result 24.

The apparatus 100 may output the dynamic model 42 and the parameter indicating the operation state of the plant based on the static model 22 and the static simulation result 24. The apparatus 100 includes a static model acquiring unit 110, a storage unit 120, a dynamic model generating unit 130, a result acquiring unit 140 and an initial state generating unit 150.

The static model acquiring unit 110 acquires the static model 22 and the static simulation result 24 that indicate the steady state of the plant. The static model acquiring unit 110 may receive the static model 22 and the static simulation result 24 that are output from the static simulator 20. Also, the static model acquiring unit 110 may also read and acquire the static model 22 and the static simulation result 24 that are stored in a database and the like. In this case, the static model acquiring unit 110 may acquire the static model 22 and the static simulation result 24 via a network or the like. Also, the static model acquiring unit 110 may also acquire the static model 22 and the static simulation result 24 by an input from the user.

The storage unit 120 stores the static model 22 and the static simulation result 24. Also, the storage unit 120 may also store information of the dynamic model 42, the parameter and the like generated by the apparatus 100. Also, the storage unit 120 may be able to store data on which the apparatus 100 performs processing. The storage unit 120 may also store each of data, models, intermediate data, calculation results, parameters and the like that are calculated (or utilized) during the process in which the apparatus 100 generates the dynamic model 42, the parameters and the like. Also, the storage unit 120 may supply, in accordance with a request from each unit in the apparatus 100, the stored data to the unit that has made the request.

The dynamic model generating unit 130 generates the dynamic model 42 based on the static model 22. The dynamic model generating unit 130 may read the information of the static model 22 from the storage unit 120 and convert the static model 22 into the dynamic model 42. The dynamic model generating unit 130 generates a dynamic model 42 including a plurality of devices respectively corresponding to a plurality of devices included in the static model 22, and a connection relation between the devices corresponding to a connection relation between the plurality of devices included in the static model 22.

The dynamic model generating unit 130 may convert the static model 22 into the dynamic model 42 based on a known conversion method. The dynamic model generating unit 130 supplies the information of the generated dynamic model 42 to the dynamic simulator 40. Also, the dynamic model generating unit 130 may output the information of the generated dynamic model 42 to the outside.

The result acquiring unit 140 acquires the static simulation result 24 of the static model 22 indicating the steady state of the plant. The result acquiring unit 140 may acquire the static simulation result 24 from the storage unit 120. Also, the result acquiring unit 140 may also acquire the static simulation result 24 output from the static simulator 20. Alternatively, the result acquiring unit 140 may also acquire the static simulation result 24 from an external database and the like. In this case, the result acquiring unit 140 may be connected to a network or the like and acquire the simulation result via the network.

The initial state generating unit 150 generates, based on the static simulation result 24, an initial value of a state parameter of the dynamic model 42 that is a model calculating a dynamic state of the plant. Here, the initial value of the state parameter includes a value indicating the operation state of the plant at one time point. For example, the state parameter includes flow rates of raw materials and materials, a temperature, a pressure, and a measuring level of each measuring apparatus, and control parameters and the like of devices included in the plant.

The initial state generating unit 150 generates the initial value of the state parameter according to a state parameter value of at least one device included in the static simulation result 24, the state parameter value calculated by a simulation using the static model 22, for example. In this case, the initial state generating unit 150 may generate the initial value of the state parameter of at least one corresponding device in the dynamic model 42.

That is, the initial state generating unit 150 converts the state parameter of the static simulation result 24 at one time point into the state parameter of the dynamic model 42 at one time point, as the initial value of the state parameter, so that the state parameter can be used by the dynamic simulator 40. Also, the initial state generating unit 150 may generate initial values of the state parameter at a plurality of corresponding time points in the dynamic model according to state parameter values of the static simulation result 24 at a plurality of time points.

The interface unit 210 receives an input, a selection, a designation and the like from a user. Also, the interface unit 210 may display models, data, drawings and the like to the user, the models, data, drawings and the like being in the process in which the dynamic simulator 40 generates the dynamic simulation result 44. The interface unit 210 may have a display screen, an input device and the like that send and receive the information. Also, the interface unit 210 may send and receive the information through wire or wireless communications with devices such as a terminal and a mobile terminal used by the user. Note that the user may include a manufacturer, a designer, an operator, an engineer, a developer, a researcher, a worker, an owner, an administrator and the like of the plant.

The dynamic simulator 40 outputs the dynamic simulation result 44 based on the dynamic model 42 generated by the dynamic model generating unit 130, and on the initial value of the state parameter generated by the initial state generating unit 150. The dynamic simulator 40 performs the dynamic simulation by setting the state parameter of the dynamic model 42 generated by the initial state generating unit 150 as the initial value and using the dynamic model 42, to generate the dynamic simulation result 44.

Note that an operation from the user may be input into the dynamic simulator 40 via the interface unit 210. Also, the dynamic simulator 40 may show, to the user via the interface unit 210, a simulation result and a situation and the like reaching to the simulation result.

As described above, the apparatus 100 according to the present embodiment outputs the dynamic model 42 and the initial value of the state parameter of the dynamic model 42 based on the static model 22. Accordingly, the simulation system 200 can easily perform the dynamic simulation to output the dynamic simulation result 44. An operation of such a simulation system 200 is described next.

Fig. 3 shows one example of an operation flow of the simulation system 200 according to the present embodiment. The simulation system 200 generates and outputs the dynamic model 42 and the dynamic simulation result 44 by performing the operation flow shown in Fig. 3.

First, the static model acquiring unit 110 acquires the static model 22 and the static simulation result 24 (S310). The static model acquiring unit 110 acquires the static model 22 and the static simulation result 24 generated by the static simulator 20. As one example, the static model acquiring unit 110 acquires the static model 22 with a text format, for example, a data file in Extensible Markup Language (XML). The static model acquiring unit 110 may store the acquired static model 22 and static simulation result 24 in the storage unit 120. Also, the static model acquiring unit 110 may also supply the acquired static model 22 to the dynamic model generating unit 130 and the acquired static simulation result 24 to the result acquiring unit 140.

Next, the dynamic model generating unit 130 converts the static model 22 into the dynamic model 42 (S320). For example, the dynamic model generating unit 130 converts data of the devices and the like included in the static model 22 into the dynamic model 42 by using a conversion algorithm, a conversion table and the like. In this case, the conversion table and the like may be stored in the storage unit 120.

Next, the result acquiring unit 140 acquires the state parameter of the plant from the static simulation result 24 (S330). The result acquiring unit 140 may acquire the state parameter values at a plurality of time points.

Next, the initial state generating unit 150 generates the initial value of the state parameter of the dynamic model 42 (S340). The initial state generating unit 150 may convert the state parameter value of the static model 22, that is acquired by the result acquiring unit 140, into the state parameter used by the dynamic simulator 40 as the initial value of the state parameter. For example, the initial state generating unit 150 converts a unit, a physical amount, a variable and the like of the state parameter value of the static model 22 to generate a state parameter that can be processed by the dynamic model 42.

Next, the dynamic simulator 40 performs the dynamic simulation by applying, to the dynamic model 42 generated by the dynamic model generating unit 130, the initial value of the state parameter generated by the initial state generating unit 150 (S350). The dynamic simulator 40 may calculate a temporal change of each parameter so that the dynamic model 42 meets the initial value of the state parameter. Accordingly, the dynamic simulator 40 can output the dynamic simulation result 44.

As described above, because the apparatus 100 according to the present embodiment automatically generates the initial value of the state parameter that can be processed by the dynamic simulator 40, the simulation by the dynamic simulator 40 can be smoothly performed. Also, the apparatus 100 generates the initial values of the state parameter at a plurality of time points; accordingly, the dynamic simulator 40 can efficiently calculate the temporal change of each parameter to output the dynamic simulation result 44.

Accordingly, a work of determining the initial values of the state parameter by a user through trial and error can be saved. Note that it is desirable that the apparatus 100 generates the initial values of the state parameter at more time points. Because the apparatus 100 generates the initial value of the state parameter based on the static model 22, the apparatus 100 can rapidly generate the initial value of the state parameter without analyzing complicated differential equations.

Note that although an example in which the apparatus 100 performs a conversion into the dynamic model 42 in S320 and then generates the initial value of the state parameter in S330 and S340 has been described in Fig. 3, the apparatus 100 is not limited to this. Because the operations in S320, S330 and S340 can be respectively performed independently, the apparatus 100 may also perform the operations in S330 and S340 and then perform the operation in S320. Also, the apparatus 100 may also perform the operation in S320 and the operations in S330 and S340 in parallel.

Note that in the dynamic simulation of the simulation system 200, the dynamic model 42 and the dynamic simulation result 44 may be adjusted according to an input from the user. In this case as well, because the apparatus 100 has already determined the dynamic model 42 and the initial value of the state parameter, a range of the adjustment by the user is set to a more limited range, and the working efficiency can be enhanced. That is, the simulation system 200 can output a more accurate dynamic simulation result 44 even if the user is not conversant with the operation of the plant, the dynamic simulator 40 and the like.

Also, the simulation system 200 according to the present embodiment can perform the operator training according to the operation training system and the like before the completion of the actual plant. In this case, the dynamic simulator 40 can set the state parameter of the dynamic model 42 generated by the initial state generating unit 150 as the initial value to simulate a dynamic state change of the dynamic model 42 from any state in accordance with the training operation of the operator. Accordingly, because the simulation system 200 can efficiently perform the simulation, the operator training can be smoothly performed.

An example in which the simulation system 200 according to the present embodiment described above outputs the dynamic model 42 and the dynamic simulation result 44 based on the static model 22 is described. Here, the simulation system 200 may also output a plurality of dynamic simulation results 44, including the dynamic simulation result 44, by using the static model 22, and a plurality of static simulation results 24, including the static simulation result 24, based on the static model 22. Such a simulation system 200 is described next.

Fig. 4 shows a first modified example of the simulation system 200 according to the present embodiment. In the simulation system 200 in the first modified example, operations that are substantially the same as the operations of the simulation system 200 according to the present embodiment shown in Fig. 2 are assigned with the same reference numerals as those of the operations of the simulation system 200 according to the present embodiment shown in Fig. 2, and the descriptions thereof are omitted. The simulation system 200 of the first modified example outputs the plurality of dynamic simulation results 44 corresponding to a plurality of scenarios of the plant, for example.

The static simulator 20 of first modified example calculates and outputs a plurality of corresponding static simulation results 24 by using one static model 22 in accordance with a plurality of different operation conditions (conditions of steady states) corresponding to the plurality of scenarios of the plant. In this case, the static model acquiring unit 110 acquires the one static model 22 and the plurality of static simulation results 24.

Then, the dynamic model generating unit 130 reads the static model 22 from the storage unit 120 to generate the dynamic model 42. Also, the result acquiring unit 140 acquires the plurality of static simulation results 24 respectively corresponding to a plurality of steady states of the plant corresponding to the plurality of scenarios. That is, the result acquiring unit 140 acquires a plurality of state parameters, including the state parameter, corresponding to the plurality of operation conditions of the plant. Also, the result acquiring unit 140 may also acquire the state parameter values at a plurality of time points for each of the plurality of operation conditions of the plant.

Then, the initial state generating unit 150 generates a plurality of initial values, including the initial value, corresponding to the plurality of scenarios, of the state parameter of the dynamic model 42 based on the simulation result for the plurality of steady states. The initial state generating unit 150 generates the initial value of the state parameter of the dynamic model 42 for each of the plurality of operation conditions of the plant. Accordingly, the dynamic simulator 40 can perform the dynamic simulation for each of the plurality of operation conditions of the plant. Therefore, the simulation system 200 of the first modified example can output the plurality of dynamic simulation results 44 corresponding to the plurality of operation conditions of the plant.

Accordingly, the simulation system 200 of the first modified example can efficiently grasp the operation of the plant under various operation conditions. Also, the simulation system 200 of the first modified example can efficiently generate not only scenarios of the steady operation of the plant but also scenarios of at least a part of a process in which the plant transits from the start to the steady operation, at least a part of a process in which the plant transits from the steady operation to shutdown, or the like.

Although an example in which the dynamic model generating unit 130 according to the present embodiment described above generates the dynamic model 42 based on the static model 22 is described, the dynamic model generating unit 130 is not limited to this. The dynamic model generating unit 130 may also generate the dynamic model 42 based on the static model 22, and the piping and instrumentation diagram data 32 described in Fig. 1. In this case, the dynamic model generating unit 130 may acquire the piping and instrumentation diagram data 32 from the plant engineering software 30. Also, the plant engineering software 30 may generate and output the piping and instrumentation diagram data 32 based on the static model 22.

Accordingly, the dynamic model generating unit 130 can generate a more detailed dynamic model 42. Note that if the dynamic model generating unit 130 generates the dynamic model 42 based on the static model 22 and the piping and instrumentation diagram data 32, a work of model conversion and the like performed by the user may occur. Such a work can be performed via the interface unit 210.

However, as already described, even if the plants to be simulated are the same or data and the like of the used devices have common parts, there may be no compatibility between the static simulator 20, the plant engineering software 30 and the dynamic simulator 40. Also, if the scale of the plant to be simulated is large, a lot of time and labor is necessary even only for the generation of such a dynamic model 42. For example, several man-months were also required in some cases even only for arrangements of units and the like and execution of inputs of parameters.

Also, because the manual generation of the dynamic model 42 includes operating the dynamic simulator 40 and editing the model by a user, a user who is acquainted with the operation of the dynamic simulator 40 is required. That is, the working efficiency and the man-hour vary depending on the proficiency level of the user to the dynamic simulator 40, and it may be difficult to smoothly perform the plant design.

Here, the dynamic model generating unit 130 according to the present embodiment may automatically generate the dynamic model 42 based on the static model 22 and the piping and instrumentation diagram data 32 to improve the efficiency of the plant design. An apparatus 100 having such a dynamic model generating unit 130 is described next. Note that in the present embodiment, a device, a unit, an item and the like are collectively called a "device".

Fig. 5 shows a second modified example of the simulation system 200 according to the present embodiment. In the simulation system 200 of the second modified example, operations that are substantially the same as the operations of the simulation system 200 according to the present embodiment shown in Fig. 2 are assigned with the same reference numerals, and the descriptions thereof are omitted. The simulation system 200 of the second modified example further includes the plant engineering software 30. As described in Fig. 1, the plant engineering software 30 generates and outputs the piping and instrumentation diagram data 32.

The apparatus 100 of the second modified example can generate the dynamic model 42 by matching devices to each other, the devices respectively included in the static model 22 and the piping and instrumentation diagram data 32 that have no compatibility with each other, based on their relations and the like. The apparatus 100 of the second modified example further includes a piping and instrumentation diagram data acquiring unit 220 and a matching unit 230.

The piping and instrumentation diagram data acquiring unit 220 acquires the piping and instrumentation diagram data 32 of the plant. The piping and instrumentation diagram data acquiring unit 220 may receive the piping and instrumentation diagram data 32 that is output from the plant engineering software 30. Also, the piping and instrumentation diagram data acquiring unit 220 may also read and acquire the piping and instrumentation diagram data 32 stored in a database and the like. In this case, the piping and instrumentation diagram data acquiring unit 220 may acquire the piping and instrumentation diagram data 32 via a network or the like. Also, the piping and instrumentation diagram data acquiring unit 220 may also acquire the piping and instrumentation diagram data 32 according the input from the user.

Note that the interface unit 210 of the second modified example may display models, data, drawings and the like to the user, the models, data, drawings and the like in the process in which the apparatus 100 generates the dynamic model 42. Also, the interface unit 210 may receive an input, a selection, a designation and the like from the user in the process in which the apparatus 100 generates the dynamic model 42. Also, the interface unit 210 may also be included in the apparatus 100. Also, the storage unit 120 of the second modified example stores the static model 22, the piping and instrumentation diagram data 32, and the input data and the like from the user.

The matching unit 230 matches the devices included in the static model 22 with the devices included in the piping and instrumentation diagram data 32 to identify a device-to-device correspondence relation. The matching unit 230 may perform the matching based on the device information and the like added to the devices. Also, the matching unit 230 may perform the matching based on a connection relation in the static model 22 and a connection relation in the piping and instrumentation diagram data 32. The matching unit 230 may convert the static model 22 and the piping and instrumentation diagram data 32 that have no compatibility with each other respectively into comparable models, and then perform the matching. The matching unit 230 has the model converting unit 232 and the matching processing unit 234.

The model converting unit 232 converts the static model 22 and the piping and instrumentation diagram data 32 respectively into a first model that is based on the static model 22 and a second model that is based on the piping and instrumentation diagram data 32, the first model and the second model having a common representation format. The model converting unit 232 may perform conversion into a common representation format for each device respectively arranged in the static model 22 and the piping and instrumentation diagram data 32 to generate the first model and the second model. Here, the common representation format shows information of connections between the respective elements or an attribute and the like of each element included in the static model 22 and the piping and instrumentation diagram data 32 in a text format. For example, some or all of the information or the attribute and the like may also be shown as data in an Extensible Markup Language (XML) format.

The matching processing unit 234 matches devices included in the first model with devices included in the second model. The matching processing unit 234 may match the devices to each other based on names and the like of the devices. Also, the matching processing unit 234 may match the devices to each other according to a designation of the user. Also, the matching processing unit 234 may also match the devices to each other based on topology (geometrical information), an attribute, a connection state with another device, and the like of a device.

The dynamic model generating unit 130 of the second modified example generates the dynamic model 42 that is a model in a dynamic state of the plant based on the matching result by the matching unit 230. The dynamic model generating unit 130 generates the dynamic model 42 by using connection relations between a plurality of devices in the piping and instrumentation diagram data 32 and parameters of devices respectively corresponding to a plurality of devices in the static model 22. The dynamic model generating unit 130 has an integrated model generating unit 132 and a converting unit 134.

The integrated model generating unit 132 generates an integrated model by using the matching result and integrating the first model and the second model. For example, the integrated model generating unit 132 generates the integrated model based on a connection between the matched devices. The integrated model generating unit 132 generates the connection information of the devices in the integrated model based on the matching result and the second model, for example. Also, the integrated model generating unit 132 may generate the device parameter, the physical property information and the like of the integrated model based on the matching result and the first model. The integrated model may have a common representation format with those of the first model and the second model.

The converting unit 134 converts the integrated model generated by the integrated model generating unit 132 into the dynamic model 42. For example, the converting unit 134 generates the dynamic model 42 by using equations that use differentiation and integration of a plurality of parameters based on physical connection relations between respective devices and operation conditions of the respective devices in the integrated model.

The apparatus 100 of the second modified example described above can generate the dynamic model 42 based on the static model 22 and the piping and instrumentation diagram data 32. Therefore, the dynamic simulator 40 can output a dynamic simulation result 44 by using the dynamic model 42 and the initial value of the state parameter generated by the apparatus 100 and simulating the operation of the plant. The operation of such a simulation system 200 of the second modified example is described next.

Fig. 6 shows one example of an operation flow of the simulation system 200 of the second modified example. The simulation system 200 of the second modified example accurately generates the dynamic model 42 by performing the operation flow shown in Fig. 6 to output the dynamic simulation result 44.

First, the static model acquiring unit 110 acquires the static model 22 and the static simulation result 24 (S610). Because the acquiring the static model 22 and the static simulation result 24 by the static model acquiring unit 110 is described by using Fig. 3, the description is omitted here.

Next, the piping and instrumentation diagram data acquiring unit 220 acquires the piping and instrumentation diagram data 32 (S620). As one example, the piping and instrumentation diagram data acquiring unit 220 acquires the piping and instrumentation diagram data 32 by a data file in the text format. The piping and instrumentation diagram data acquiring unit 220 may store the acquired static model 22 in the storage unit 120. Also, the piping and instrumentation diagram data acquiring unit 220 may also supply the acquired piping and instrumentation diagram data 32 to the matching unit 230.

Next, the model converting unit 232 converts the static model 22 respectively into the first model and the piping and instrumentation diagram data 32 into the second model (S630). The model converting unit 232 converts the static model 22 into the first model by using a first conversion table, for example. The first conversion table may be a table in which a correspondence relation between the static model 22 and the first model is registered in advance. In this case, the first conversion table may be stored in the storage unit 120.

That is, the model converting unit 232 may read the first conversion table from the storage unit 120 to convert the static model 22 into the first model. The first model may be a model including device information added to each device arranged in the static model 22. The device information may include the names, the attributes and the like of the devices.

Also, the model converting unit 232 converts the piping and instrumentation diagram data 32 into the second model by using a second conversion table, for example. The second conversion table may be a table in which a correspondence relation between the piping and instrumentation diagram data 32 and the second model is registered in advance. In this case, the second conversion table may be stored in the storage unit 120. That is, the model converting unit 232 may read the second conversion table from the storage unit 120 to convert the piping and instrumentation diagram data 32 into the second model. The second model may be a model including device information added to each device arranged in the piping and instrumentation diagram data 32. The device information may include the names, the attributes and the like of the devices.

Next, the matching processing unit 234 matches the devices included in the first model with the devices included in the second model (S640). The matching processing unit 234 identifies a device-to-device correspondence relation based on a result of comparing the device information added to the devices included in the static model 22 with the device information added to the devices included in the piping and instrumentation diagram data 32. For example, the matching processing unit 234 extracts sets of devices whose names match each other, as corresponding devices. The names are respectively included in the device information of the respective devices included in the first model and included in the device information of the respective devices included in the second model.

Also, instead of the names of the devices, the matching processing unit 234 may also extract, respectively from the first model and the second model, sets of devices whose types, attributes, set parameters and the like match with each other, as the corresponding devices. The matching processing unit 234 may set the extracted corresponding devices as a matching result.

Next, the matching processing unit 234 determines whether to continue or terminate the matching (S650). For example, the matching processing unit 234 may display the matching result to the user via the interface unit 210 to make the user designate to continue (S650: No) or terminate (S650: Yes) the matching.

Alternatively, the matching processing unit 234 may calculate a percentage of the matched devices among all of the devices included in the static model 22 as a matching rate, and determine whether to continue the matching or not in accordance with the matching rate. For example, the matching processing unit 234 may determine to terminate the matching (S650: Yes) if the matching rate exceeds a predetermined threshold. Also, the matching processing unit 234 may determine to continue the matching (S650: No) if the matching rate is equal to or less than the predetermined threshold.

If the matching processing unit 234 determines to continue the matching (S650: No), the matching processing unit 234 receives an input from the user via the interface unit 210 (S660). An indication of a type and the like of the matching that is the next to be performed may also be input in the interface unit 210. An indication indicating that the matching result is appropriate may also be input in the interface unit 210 by the user.

Also, if a set of devices, among the matching result, that actually do not correspond to each other is extracted, an indication indicating that the set of devices is excluded from the matching result may be input in the interface unit 210 by the user. Also, a designation indicating that a first device in the static model 22 and a second device in the piping and instrumentation diagram data 32 are the corresponding devices may also be input in the interface unit 210 from the user. That is, if there are devices that cannot be matched with the other left, the matching processing unit 234 may further receive a designation of a device-to-device correspondence relation between the devices in the static model 22 and the devices in the piping and instrumentation diagram data 32.

The matching processing unit 234 performs matching processing in response to the indication of the user (S640). Also, the matching processing unit 234 may increase or decrease a number of sets of corresponding devices as the matching result according to the indication of the user. Also, if there is another set of devices corresponding to the designation of the user, the matching processing unit 234 may similarly increase or decrease the number of the sets of the corresponding devices. Also, the matching processing unit 234 may also perform a different type of matching from that of the previous matching. The matching processing unit 234 may repeat the operations in S640 to S660 until the matching is terminated. Also, if the operations in S640 to S660 have been repeated for a predetermined times, the matching processing unit 234 may also terminate the matching.

Next, the integrated model generating unit 132 generates the integrated model by using the matching result (S670). The integrated model generating unit 132 may set, for example, connection information of parts including at least the matched devices among the second model as the connection information of the devices in the integrated model. Also, the integrated model generating unit 132 may set the parameters, the physical property information and the like of the matched devices included in the first model as the parameters, the physical property information and the like of the corresponding devices in the integrated model.

Next, the converting unit 134 converts the integrated model into the dynamic model 42 (S680). Accordingly, the apparatus 100 of the present embodiment can output the dynamic model 42. That is, the operations in S610 to S680 as described above are the operations substituted for the operations of generating the dynamic model 42 in S310 to S320 described in Fig. 3.

Next, the result acquiring unit 140 acquires the state parameter of the plant from the static simulation result 24 (S690). Next, the initial state generating unit 150 generates the initial value of the state parameter of the dynamic model 42 (S700). Because the operations in S690 to S700 are substantially the same as the operations in S330 and S340 described in Fig. 3, the descriptions for them are omitted here.

As described above, because the apparatus 100 of the second modified example generates the dynamic model 42 and the initial value of the state parameter of the dynamic model 42, the dynamic simulator 40 can simulate the operation of the plant (S710). Because the apparatus 100 can converts the static model 22 and the piping and instrumentation diagram data 32 that have different formats from each other into the first model and the second model that have substantially the same format, the matching unit 230 can easily perform the matching. Also, the apparatus 100 can automatically perform the matching by searching for the devices having the matched device information.

Also, the apparatus 100 makes the user check the matching result to acquire an indication for a further matching. Accordingly, the apparatus 100 can also match the devices having device information that do not match with each other. Also, the user can acquire the matching result with high perfection by only indicating lacking to-be-matched targets based on the result obtained by the matching. Also, the user can acquire the matching result with high perfection by only indicating a wrong matching result based on the result obtained by the matching.

Also, the integrated model generating unit 132 uses the first model converted from the static model 22 having the device parameter and the physical property information to determine the device parameter, the physical property information and the like of the devices in the integrated model. Then, the integrated model generating unit 132 uses the second model converted from the piping and instrumentation diagram data 32 having the detailed connection information of the devices to determine the connection information of the devices and the like in the integrated model. Accordingly, the apparatus 100 can extract, from an appropriate model, the device parameters, the physical property information, the connection information of the devices and the like that are necessary for the dynamic model 42, and incorporate the extracted ones to the integrated model.

Also, the apparatus 100 can easily convert the integrated model into the dynamic model 42 based on the matching result by setting substantially the same format to a format that is possible to be converted into the dynamic model 42. In this way, because the apparatus 100 according to the present embodiment can easily generate the dynamic model 42 that can be operated by the dynamic simulator 40, working hours and labor of a user can be reduced. Because such working hours and labor of the user are greater as a scale of the plant is larger, it is also possible to reduce the man-hours of the user for manually creating the dynamic model 42 to approximately 60%, for example.

Also, because the apparatus 100 can generate the dynamic model 42 without using the dynamic simulator 40, an appropriate dynamic model 42 can be generated irrelevantly to the proficiency level of the user to the dynamic simulator 40. As described above, according to the apparatus 100 according to the present embodiment, the working efficiency of the generation of the dynamic model 42 can be improved and the plant design can be smoothly performed.

Fig. 7 shows one example of the first model converted by the model converting unit 232 according to the present embodiment converts. Also, Fig. 8 shows one example of the second model converted by the model converting unit 232 according to the present embodiment. Fig. 7 and Fig. 8 respectively show one example of the conversion result relative to the same device. Even if the device is the same, because the static model 22 and the piping and instrumentation diagram data 32 respectively have information corresponding to purposes, the first model and the second model, that have the format in common with each other, converted by the model converting unit 232 still almost have no item in common with each other in some cases.

In the cases of the examples of Fig. 7 and Fig. 8, for example, because the "CV1" being a "tag name" is in common with each other as a name of a device, the matching processing unit 234 sets the devices having the "CV1" being the tag name in the first model and the second model as the corresponding devices. However, for example, in the examples of Fig. 7 and Fig. 8, if the tag names are different from each other it is difficult to automatically extract the devices as the corresponding devices. Note that although Fig. 7 and Fig. 8 show the first model and the second model in a table format for an easy understanding, the format is not limited to this and the first model and the second model may be described in various formats. The first model and the second model are shown in XML data, for example.

Fig. 9 shows one example of the static model 22 according to the present embodiment. Fig. 9 is an example of the static model 22 described for a plurality of devices from an input unit 602 to an output unit 604. Note that in Fig. 9 the description for the physical property information of each device is omitted. The static model 22 includes a heat exchanger 610, a reactor 620, a tank 630, a compressor 640, a pump 650 and a valve 660.

Fig. 10 shows one example of the piping and instrumentation diagram data 32 according to the present embodiment. Fig. 10 is an example of the piping and instrumentation diagram data 32 described for a plurality of devices from an input unit 702 to an output unit 704. The piping and instrumentation diagram data 32 includes a valve 706, a first heat exchanger 712, a second heat exchanger 714, a reactor 720, a tank 730, a compressor 740, a valve 708, a first pump 752, a second pump 754 and a valve 760.

The piping and instrumentation diagram data 32 shown in Fig. 10 is data indicating parts substantially the same as the static model 22 shown in Fig. 9. Because the piping and instrumentation diagram data 32 has more detailed connection information of the devices than that of the static model 22, information of the devices such as the valve 706 and the valve 708 have been added to the piping and instrumentation diagram data 32, for example. Note that the piping and instrumentation diagram data 32 does not include the physical property information and the like of each device.

Comparing Fig. 9 with Fig. 10, the reactor 620 and the reactor 720, the tank 630 and the tank 730, the compressor 640 and the compressor 740, and the valve 660 and the valve 760 are respectively the corresponding devices, and it is desirable to extract these devices by the matching. However, these devices may be described by different names and attributes, as described in Fig. 7 and Fig. 8. For example, the name of one of the reactor 620 and the reactor 720 is "REACT1" and the name of the other thereof is "RA-01", and accordingly, it is difficult to automatically match the devices.

Also, in the static model 22, the heat exchanger 610 and the pump 650 are respectively shown as one ideal device. On the other hand, in the piping and instrumentation diagram data 32, two devices, such as the first heat exchanger 712 and the second heat exchanger 714, and the first pump 752 and the second pump 754, are shown, and a configuration and a connection may be different from those in the static model 22. This is a result of connecting a plurality of devices in parallel or in series by taking installation locations, device performance and the like into account to meet the specification of the device that is considered in the static model 22, and the piping and instrumentation diagram data 32 shows that the configuration diagram is closer to the design drawing of the actual plant. Note that even in this case, because the names of the plurality of devices may be respectively different and the connection relations are also different, it is difficult to automatically perform the matching.

It is described that the apparatus 100 of the second modified example can perform the matching by receiving the indication from the user in such a case. In addition to this, the apparatus 100 may also perform the matching by taking a relation of the device information, the connection relation between the devices and the like into account. For example, the apparatus 100 registers the relation of the device information in advance.

In the examples of Fig. 7 and Fig. 8, for example, the apparatus 100 stores in advance, in the storage unit 120, that the "valve object" and the "ball valve" mean the devices that have different names from each other but correspond to each other. Also, in the examples in Fig. 9 and Fig. 10, the apparatus 100 stores in advance, in the storage unit 120, that the "REACT1" and the "RA-01" mean the devices that have different names from each other but correspond to each other. The matching processing unit 234 can determine whether the devices even having different names from each other are the corresponding devices or not by reading such a relation of the device information as a reference from the storage unit 120, and can match the devices.

Also, the matching processing unit 234 may also identify a device-to-device correspondence relation based on the result of comparing the connection relation between the devices in the static model 22 with the connection relation between the devices in the piping and instrumentation diagram data 32. For example, the matching processing unit 234 may determine that the valve 660 connected to the output unit 604 and the valve 760 connected to the output unit 704 are the corresponding devices. Note that because the valve 660 and the valve 760 have the same name "CV1", the matching processing unit 234 may also determine that the valve 660 and the valve 760 are the corresponding devices based on the name.

Then, the matching processing unit 234 compares the pump 650 that is connected to an input end of the valve 660 with the first pump 752 and the second pump 754 that are connected to an input end of the valve 760 after matching the valve 660 with the valve 760. The connection between the first pump 752 and the second pump 754 is a parallel connection in which the input ends the two devices are connected, and so are the output ends of the two devices. That is, it can be determined that one device in the static model 22 is realized by two devices, that is, the first pump 752 and the second pump 754 in the piping and instrumentation diagram data 32. In such a case, the matching processing unit 234 may determine that the pump 650, and the first pump 752 and the second pump 754 are the corresponding devices.

Also, after matching the pump 650 with the first pump 752 and the second pump 754, the matching processing unit 234 compares the tank 630 connected to an input end of the pump 650 with the valve 708 connected to an input end of the first pump 752 and to an input end of the second pump 754. In the connection to the tank 630, an input end of the tank 630 is connected to one device and two output ends of the tank 630 are respectively connected to one device. An input end of the valve 708 is similarly connected to one device, but there is only one output end on the valve 708. Here, the matching processing unit 234 may determine that the tank 630 and the valve 708 are not the corresponding devices.

The matching processing unit 234 may also further compare a next device connection after performing the determination of the tank 630 and the valve 708. For example, because the piping and instrumentation diagram data 32 has more detailed connection information of the devices than that of the static model 22, the matching processing unit 234 may determine that the valve 708 in the piping and instrumentation diagram data 32 is the device that does not exist in the static model 22. Then, the matching processing unit 234 compares the tank 630 with the tank 730 connected to the input end of the valve 708.
Further, because the connection in the tank 630 is in substantially the same form as that of the connection in the tank 730, the matching processing unit 234 may determine that the tank 630 and the tank 730 are the corresponding devices.

In this way, the matching processing unit 234 may identify the correspondence relation between the devices based on the connection information of the devices. Accordingly, the matching processing unit 234 can perform the matching even if the names of the devices are different from each other. Also, the matching processing unit 234 may also identify the corresponding devices by performing another matching method of a different type, such as matching according to the names of the devices, and then further perform the matching processing from the connection relation between the identified devices.

Also, a designation indicating that a first device in the static model 22 and a second device in the piping and instrumentation diagram data 32 are the corresponding devices may be input in the matching processing unit 234. Such an input may be performed by the operation in S660 in Fig. 6, or may alternatively be made from the interface unit 210 in the operation in S640. The matching processing unit 234 may further identify, in response to receiving the designation, a device-to-device correspondence relation based on a result of respectively comparing a connection relation between the first device and each device in the static model 22 with a connection relation between the second device and each device in the piping and instrumentation diagram data.

Also, as described in Fig. 6 as well, the matching processing unit 234 can make the user check whether the matching is appropriate or not. Therefore, the matching processing unit 234 can accurately perform a more detailed matching. Note that the matching performed by the apparatus 100 based on the relation between the device information, the connection relation between the devices and the like may also be performed based on a known technology, that is called ontology, in computer science, information science and the like.

Here, the ontology may be explained as a formal expression in which knowledge is considered as a set of relations between concepts. For example, by defining a word using a plurality of concepts and relations between the concepts, the word can be distinguished from another word, can be discriminated from a homonym, and can be determined to be a synonym for another word although having different spelling and so on, so that it is possible that the word can be effectively treated as knowledge. As one example, by associating the word "pipe" with concepts "cylinder", "tubular", "gas" and the like, it can be known that the word "pipe" means a tube for passing liquid, gas and the like therethrough, and it can be determined that the word "pipe" is not a "pipe" indicating a tool for smoking a cigarette, a wind instrument, and a function of delivering a value and the like of data in a program. The ontology may also be what described in Riichiro MIZOGUCHI, Science of Intelligence, Ohmsha, January 20, 2005, and may also be what described in What are ontologies, Retrieved November 20, 2017 , from https://www.ontotext.com/knowledgehub/fundamentals/what-are-ontologies.

Here, association information according to such ontology may be defined for each device in the static model 22 and each device in the piping and instrumentation diagram data 32, to be utilized for the matching. For example, the model converting unit 232 uses the ontology to convert the static model 22 into the first model and convert the piping and instrumentation diagram data 32 into the second model. For example, the model converting unit 232 uses the ontology of the static model 22 to generate the first model that is a sematic model indicating the respective devices and the connection relation between the devices in the static model 22. Also, the model converting unit 232 uses the ontology of the piping and instrumentation diagram data 32 to generate the second model that is a sematic model indicating the respective devices and the connection relation between the devices in the piping and instrumentation diagram data 32.

Fig. 11 shows one example of the first model converted by using the ontology by the model converting unit 232 according to the present embodiment. Fig. 11 shows a connection relation between the respective devices from the input unit 802 to the output unit 804. In the first model, information of each device in the static model 22 and the connection relation between the respective devices shown in Fig. 9 are incorporated. The first model shows conversion results respectively corresponding to the devices. For example, the heat exchanger 610 is converted into the device 810 having the name "HEX1", the reactor 620 is converted into the device 820 having the name "REACT1", the tank 630 is converted into the device 830 having the name "TANK1", the compressor 640 is converted into the device 840 having the name "COMP1", the pump 650 is converted into the device 850 having the name "PUMP1", and the valve 660 is converted into the device 860 having the name "CV1".

Note that the association information according to the ontology is associated with each device shown in Fig. 11. For example, the device 860 has type information being the "valve object", and accordingly, pieces of association information being the "valve object" and the "ball valve" are associated with the device 860. That is, the association information meaning the valve is associated with the device 860. Also, association information showing that the device associated with the association information being the "pump" may be connected may also be associated with the device 860.

Fig. 12 shows one example of the second model converted by using the ontology by the model converting unit 232 according to the present embodiment. Fig. 12 shows a connection relation between the respective devices from the input unit 902 to the output unit 904. Similar to the first model, in the second model, information of the respective devices in the piping and instrumentation diagram data 32 shown in Fig. 10 and the connection relation between the respective devices are incorporated. Also, the association information by the ontology is associated with each device shown in Fig. 12. For example, the device 960 has type information being the "ball valve", and accordingly, pieces of association information being the "valve object" and the "ball valve" are associated with the device 960. That is, association information meaning the valve is associated with the device 960. Also, association information showing that a device associated with the association information being the "pump" may be connected may also be associated with the device 960.

Such an association between the information of the types of the devices included in the first model and in the second model and the association information may be registered in advance in the storage unit 120 by using a table and the like. The storage unit 120 may store these associations as a first table and a second table, for example. The model converting unit 232 associates each device with the association information based on such registered information, and also models the connections between the respective devices as pieces of graphic information as shown in Fig. 11 and Fig. 12.

Then, the matching processing unit 234 performs the matching processing based on the association information. For example, the matching processing unit 234 determines that the device 860 and the device 960 are the corresponding devices based on the pieces of association information that are the "valve object" and the "ball valve" respectively included in the device 860 and the device 960. Because the matching processing unit 234 utilizes such association information based on the ontology, the matching processing unit 234 can match the devices even if the devices have different names from each other.

Also, the matching processing unit 234 may also perform the matching processing based on the association information about the connection. For example, the device 850 with which the association information being the "pump" is associated is connected to the device 860. According to this, the matching processing unit 234 may determine that a connection destination of the device 960 corresponding to the device 860 may be a device with which the association information being the "pump" is associated. Also, a device 952 and a device 954 that are associated with the association information being the "pump" are connected in parallel, and according to this, the matching processing unit 234 may determine that the device 850, and the device 952 and the device 954 are the corresponding devices.

In this way, the apparatus 100 of the second modified example can also determine a device-to-device correspondence relation between devices having different names and different connections from each other by using a technology, such as the ontology, in the computer science, the information science and the like. That is, the apparatus 100 can accurately perform the matching processing by using a technology that is established systematically. Also, along with a development of such a technology, the accuracy and the efficiency of the apparatus 100 can also be improved.

Although the above has described that the apparatus 100 of the second modified example shows the matching result by the matching processing unit 234 to the user, and the user inputs an evaluation relative to the matching result and an indication and the like for a further matching, the apparatus 100 is not limited to this. For example, the matching processing unit 234 outputs, via the interface unit 210, matching candidates of the devices included in the static model 22 and the devices included in the piping and instrumentation diagram data 32. In response to an approval of the matching candidates, the matching processing unit 234 may match the devices to each other that have been set as the matching candidates.

Accordingly, the apparatus 100 can preferentially match the devices that are designated by the user. Also, because the apparatus 100 can perform the matching based on an order of priority made by the user, generation of the dynamic model 42 that is to be simulated can be efficiently generated.

Also, the matching processing unit 234 may also first perform the matching processing and then show the matching candidates to the user. In this case, the matching processing unit 234 may show, to the user, a number, a percentage and the like of the devices that can be matched according to the matching result of the matching candidates. Also, the matching processing unit 234 may respectively perform the matching processing on a plurality of matching candidates and show, to the user along with the plurality of matching candidates, the number, the percentage and the like of the devices that can be matched corresponding to each of the plurality of matching candidates.

Also, the matching processing unit 234 may also determine a priority of the matching candidates from the number, the percentage and the like of the devices that can be matched to set a display order of the matching candidates, display highlighting and the like. Also, the matching processing unit 234 may also output only the matching candidates having a priority that is equal to or greater than a reference. Also, the matching processing unit 234 may also show a progress of the matching processing to the user. In this case, the matching processing unit 234 may also further include a progress information output unit to output progress information indicating the progress of the matching of each device in the static model 22 and each device in the piping and instrumentation diagram data 32.

Although the above has described that the simulation system 200 of the second modified example generates and outputs the dynamic model 42 and also outputs the dynamic simulation result 44 by the dynamic simulator 40, the simulation system 200 is not limited to this. As described in Fig. 4, the simulation system 200 of the second modified example may output a plurality of dynamic simulation results 44 corresponding to a plurality of scenarios of the plant. In this case, the simulation system 200 may output a plurality of dynamic simulation results 44 by using a plurality of static models 22.

Also, the apparatus 100 may also output the matching result from the matching unit 230. Also, the apparatus 100 may also accumulate the matching result by the matching unit 230 in the storage unit 120 or an external database and the like. Accordingly, because the apparatus 100 can accumulate an appropriate matching result, the apparatus 100 can utilize the matching result for a next plant design, improvement and modification. For example, the apparatus 100 can grasp changed portions and the like by comparing the static model having been used for the previous design with the static model used for the present design. Accordingly, the apparatus 100 can perform, by utilizing the previous matching result, the matching processing on the changed portions only for the devices that are not changed in the present design.

Also, the devices, among the matching result of the respective devices, that are input by the user as the devices to be matched may be stored in the database. Also, in the next matching and thereafter, if a corresponding combination exists in the first model and the second model, the matching processing unit 234 may add the combination as the matching result. Accordingly, an appropriate matching that cannot be automatically picked up by certain algorithm can be added to the matching result without the indication of the user.

Also, among the matching result of the respective devices, the devices that are inappropriately matched by the user may be stored in the database. Then, if a combination corresponding to the next matching result and thereafter exists in the matching result, the matching processing unit 234 may also remove the combination from the matching result. Accordingly, the inappropriately matching result that is automatically picked up by certain algorithm can be removed without the indication of the user.

As described above, the apparatus 100 can improve the working efficiency of generation of the dynamic model 42 by outputting the matching result only. Note that if the matching accuracy is improved by accumulating the matching result and the like, the apparatus 100 may also omit the operation of the user input shown as S660 in Fig. 6. As described above, the apparatus 100 can reduce labor of manual input of the user during the process of generating the dynamic model 42, can also reduce occurrence frequency of operation mistakes, and can improve the efficiency of the plant design and creation of the operation training system.

Although an example in which the apparatus 100 according to the present embodiment described above is provided in the simulation system 200 is described, the apparatus 100 is not limited to this. The apparatus 100 may also be an apparatus that operates separately and independently from the simulation system 200. In this case, the apparatus 100 may have an interface unit 210. Also, the apparatus 100 may also have a dynamic simulator 40.

Also, various embodiments of the present invention may be described with reference to flow charts and block diagrams. Here, the block diagrams may represent: (1) steps of processes of performing operations or (2) sections of an apparatus serving to perform operations. Specific steps and sections may be implanted by at least one of a dedicated circuit, a programmable circuit supplied along with a computer-readable instruction stored on a computer-readable medium, and a processor supplied along with a computer-readable instruction stored on a computer-readable medium. The dedicated circuit may include at least one of a digital hardware circuit and an analog hardware circuit, and may include at least one of an integrated circuit (IC) and a discrete circuit. The programmable circuit may include a reconfigurable hardware circuit that includes a memory element and the like such as a logical AND, logical OR, logical XOR, logical NAND, logical NOR and another logical operation, a flip-flop, a register, a field programmable gate array (FPGA) and a programmable logic array (PLA).

The computer-readable medium may include any tangible device that can store an instruction executed by an appropriate device. As a result, the computer-readable medium having the instruction stored thereon includes a product including an instruction that can be executed to make a means for performing an operation specified in flow charts or block diagrams. As an example of the computer-readable medium, an electronic storage medium, a magnetic storage medium, an optical storage medium, an electromagnetic storage medium, a semiconductor storage medium and the like may be included. As a more specific example of the computer-readable medium, a floppy (registered trademark) disk, a diskette, a hard disk, a random access memory (RAM), a read-only memory (ROM), an erasable programmable read-only memory (EPROM or flash memory), electrically erasable programmable read-only memory (EEPROM), a static random access memory (SRAM), a compact discrete read-only memory (CD-ROM), a digital versatile disk (DVD), a Blu-Ray (registered trademark) (RTM) disk, a memory stick, an integrated circuit card and the like may be included.

The computer-readable instruction may include any of an assembler instruction, an instruction set architecture (ISA) instruction, a machine instruction, a machine-dependent instruction, a microcode, a firmware instruction, state setting data, or a code or an object code described by an arbitrary combination of one or more programming languages including an object oriented programming language such as Smalltalk, JAVA (registered trademark) and C++, and a conventional procedural programming language such as "C" programming language or a similar programming language.

The computer-readable instruction may be provided, for a processor or a programmable circuit of a general purpose computer, a specific purpose computer or another programmable data processing apparatus, locally or via a local area network (LAN) and a wide area network (WAN) such as Internet. To make a means for performing an operation specified in a flow chart or a block diagram, the computer-readable instruction may be performed. As an example of the processor, a computer processor, a processing unit, a microprocessor, a digital signal processor, a controller, a micro-controller and the like are included.

Fig. 13 shows a configuration example of a computer 1200 in which the plurality of aspects of the present invention may be entirely or partially embodied. A program installed in the computer 1200 can make the computer 1200 serve as an operation associated with an apparatus according to an embodiment of the present invention or one or more "units" of the apparatus or execute the operation or the one or more "units", and/or can make the computer 1200 execute a process according to an embodiment of the present invention or steps of the process. Such a program may be executed by a CPU 1212 to make the computer 1200 perform a specific operation associated with some or all of blocks of the flowcharts and the block diagrams described in the present specification. Also, a process according to an embodiment of the present invention or steps of the process may also be performed in a cloud environment.

The computer 1200 according to the present embodiment includes the CPU 1212, an RAM 1214, a graphic controller 1216 and a display device 1218, which are mutually connected via a host controller 1210. The computer 1200 also includes a communication interface 1222, a hard disk drive 1224, a DVD-ROM drive 1226 and an input/output unit such as an IC card drive, which are connected to the host controller 1210 via an input/output controller 1220. The computer also includes legacy input/output units such as an ROM 1230 and a keyboard 1242, which are connected to the input/output controller 1220 via the input/output chip 1240.

The CPU 1212 operates according to a program stored in the ROM 1230 and the RAM 1214 to control each unit accordingly. The graphic controller 1216 acquires image data, that is generated by the CPU 1212, in a frame buffer and the like provided in the RAM 1214, or in the graphic controller 1216 itself, and display the image data on the display device 1218.

The communication interface 1222 communicates with another electronic device via a network. The hard disk drive 1224 stores a program and data used by the CPU 1212 in the computer 1200. The DVD-ROM drive 1226 reads the program or the data from the DVD-ROM 1201 and provides the program or the data to the hard disk drive 1224 via the RAM 1214. The IC card drive reads the program and the data from an IC card and/or writes the program and the data in the IC card.

The ROM 1230 stores thereon a boot program and the like executed by the computer 1200 at the time of an activation, and/or a program depending on hardware of the computer 1200. The input/output chip 1240 may also connect various input/output units to the input/output controller 1220 via a parallel port, a serial port, a keyboard port, a mouse port and the like.

The programs are provided by a computer-readable storage medium such as the DVD-ROM 1201 or an IC card. The programs are read from the computer-readable storage medium, and are installed in the hard disk drive 1224, the RAM 1214 or the ROM 1230, that are also examples of the computer-readable storage medium, and executed by the CPU 1212. Information processing described in these programs is read by the computer 1200 and results in cooperation between the programs and pieces of hardware of various types described above. The apparatus or method may be configured by achieving an operation or processing of the information through the use of the computer 1200.

For example, if communication is performed between the computer 1200 and an external device, the CPU 1212 may execute a communication program loaded on the RAM 1214 and instruct the communication interface 1222 for a communication processing based on the processing described in the communication program. The communication interface 1222 reads transmission data stored in a transmission buffer region provided in a recording medium such as the RAM 1214, the hard disk drive 1224, the DVD-ROM 1201 or the IC card under a control of the CPU 1212 and transmits the read transmission data to a network or writes reception data received from the network in a reception buffer region and the like provided on the recording medium.

Also, the CPU 1212 may perform various types of processing on the data on the RAM 1214 so that all or necessary parts of files or database stored in an external recording medium such as the hard disk drive 1224, the DVD-ROM drive 1226 (DVD-ROM 1201), the IC card and the like are read by the RAM 1214. Next, the CPU 1212 may write back the processed data in the external recording medium.

Various types of information such as various types of programs, data, tables and database may be stored in a recording medium to be information-processed. The CPU 1212 may execute, on the read data from the RAM 1214, various types of processing including various types of operations, information processing, condition determination, conditional branch, unconditional branch, information search/replacement and the like that are described throughout the present disclosure and are designated by an instruction sequence of a program, and write back the result to the RAM 1214. Also, the CPU 1212 may search for the files in the recording medium and the information in the database and the like. For example, if a plurality of entries each having an attribute value of a first attribute associated with an attribute value of a second attribute are stored in a recording medium, the CPU 1212 may search, from the plurality of entries, for an entry in which the attribute value of the first attribute matches a designated condition, and read an attribute value of a second attribute stored in the entry, and accordingly acquire the attribute value of the second attribute associated with the first attribute that satisfies a predetermined condition.

The programs or software module according to the above description may be stored in a computer-readable storage medium on the computer 1200 or near the computer 1200. Also, a recording medium such as a hard disk or an RAM provided in a server system connected to a dedicated communication network or Internet is usable as a computer-readable storage medium so as to provide the programs to the computer 1200 via the network.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### [Reference Signs List]

10 ... generating apparatus; 20 ... static simulator; 22 ... static model; 24 ... static simulation result; 30 ... plant engineering software; 32 ... piping and instrumentation diagram data; 40 ... dynamic simulator; 42 ... dynamic model; 44 ... dynamic simulation result; 100 ... apparatus; 110 ... static model acquiring unit; 120 ... storage unit; 130 ... dynamic model generating unit; 132 ... integrated model generating unit; 134 ... converting unit; 140 ... result acquiring unit; 150 ... initial state generating unit; 200 ... simulation system; 210 ... interface unit; 220 ... piping and instrumentation diagram data acquiring unit; 230 ... matching unit; 232 ... model converting unit; 234 ... matching processing unit; 602 ... input unit; 604 ... output unit; 610 ... heat exchanger; 620 ... reactor; 630 ... tank; 640 ... compressor; 650 ... pump; 660 ... valve; 702 ... input unit; 704 ... output unit; 706 ... valve; 708 ... valve; 712 ... first heat exchanger; 714 ... second heat exchanger; 720 ... reactor; 730 ... tank; 740 ... compressor; 752 ... first pump; 754 ... second pump; 760 ... valve; 802 ... input unit; 804 ... output unit; 810 ... device; 820 ... device; 830 ... device; 840 ... device; 850 ... device; 860 ... device; 902 ... input unit; 904 ... output unit; 952 ... device; 954 ... device; 960 ... device; 1200 ... computer; 1201 ... DVD-ROM; 1210 ... host controller; 1212 ... CPU; 1214 ... RAM; 1216 ... graphic controller; 1218 ... display device; 1220 ... input/output controller; 1222 ... communication interface; 1224 ... hard disk drive; 1226 ... DVD-ROM drive; 1230 ... ROM; 1240 ... input/output chip; 1242 ... keyboard

## Claims

1. An apparatus for generating a dynamic model and a dynamic simulation result to determine a specification for at least one of a design of a plant, devices in the plant, and a sizing of the plant, and/or to check a dynamic behavior of the plant, the apparatus (100), comprising:
a static model acquiring unit (110) configured to acquire a static model (22);
a storage unit (120) configured to store the static model (22);
a result acquiring unit (140) configured to acquire a simulation result of the static model (22) indicating a first steady state of the plant;
an initial state generating unit (150) configured to generate, based on the simulation result, a first initial value of a state parameter of a dynamic model (42) that is a model calculating a dynamic state of the plant; and
a dynamic plant simulator configured to provide the dynamic simulation result (44) of the plant based on the dynamic model (42),
**characterized in that**
the initial state generating unit (150) is further configured
to convert one of a unit, a physical amount, and a variable of a state parameter value of at least one device of the plant included in the static model (22) into the first initial value of the state parameter of at least one corresponding device ot the plant in the dynamic model (42) that respectively corresponds to the at least one device included in the static model (22),
the state parameter value being calculated by a simulation using the static model (22).

2. An apparatus according to claim 1, the apparatus (100) further comprising a dynamic model generating unit (130) configured to generate the dynamic model (42) based on the static model (22).

3. An apparatus according to claim 2, wherein
the dynamic model generating unit (130) is further configured to generate the dynamic model (42) that includes:
a plurality of devices respectively corresponding to a plurality of devices included in the static model (22); and
a connection relation between devices corresponding to a connection relation between the plurality of devices included in the static model (22).

4. An apparatus according to claim 2 or 3, the apparatus (100) further comprising:
a piping and instrumentation diagram data acquiring unit (220) configured to acquire piping and instrumentation diagram data (32) of the plant; and
a matching unit (230) configured to match a device included in the static model (22) with a device included in the piping and instrumentation diagram data (32) to identify a device-to-device correspondence relation, wherein
the dynamic model generating unit (130) is further configured to generate, based on a matching result by the matching unit (230), the dynamic model (42).

5. An apparatus according to any one of claims 1 to 4, wherein
the result acquiring unit (140) is further configured to acquire the simulation result of the static model (22) for each of a plurality of steady states, including the first steady state, of the plant, and
the initial state generating unit (150) is further configured to generate, based on the simulation result for each of
the plurality of steady states, a plurality of initial values, including
the first initial value, of the state parameter of the dynamic model (42).

6. A simulation system (200) to determine a specification for at least one of a design of a plant, devices in the plant, and a sizing of the plant, and/or to check a dynamic behavior of the plant, the simulation system (200) comprising:
the apparatus (100) according to any one of claims 1 to 5;
a static simulator (20) configured to perform a static simulation to generate the static model (22); and
a dynamic simulator (40) configured to perform a dynamic simulation by setting the state parameter of the dynamic model (42) as the initial value and using the dynamic model (42).

7. A system according to claim 6, wherein the dynamic simulator (40) is further configured to set the state parameter of the dynamic model (42) as the initial value to simulate a dynamic state change of the dynamic model (42) occurring in response to a training operation of an operator.

8. A method for generating a dynamic model and a dynamic simulation result to determine a specification for at least one of a design of a plant, devices in the plant, and a sizing of the plant, and/or to check a dynamic behavior of the plant, the method comprising:
acquiring a static model (22);
storing the static model (22);
acquiring a simulation result of the static model (22) indicating a steady state of the plant;
generating, based on the simulation result, an initial value of a state parameter of a dynamic model (42) that is a model calculating a dynamic state of the plant; and
simulating a state of the plant based on the dynamic model (42), thereby providing the dynamic simulation result,
**characterized in that**
the method further comprises:
converting one of a unit, a physical amount, and a variable of a state parameter value of at least one device of the plant included in the static model (22) into the initial value of the state parameter of at least one corresponding device of the plant in the dynamic model (42) that respectively corresponds to the at least one device included in the static model (22), and
the state parameter value being calculated by a simulation using the static model (22).

9. A program which makes a computer serve as the apparatus (100) according to any one of claims 1 to 5.

10. A program which makes a computer serve as the simulation system (200) according to claim 6 or 7.

## Patentansprüche

1. Vorrichtung zum Erzeugen eines dynamischen Modells und eines dynamischen Simulationsergebnisses, um eine Spezifikation für mindestens eines von einem Entwurf einer Anlage, von Vorrichtungen in der Anlage und einer Dimensionierung der Anlage zu bestimmen und/oder um ein dynamisches Verhalten der Anlage zu überprüfen, wobei die Vorrichtung (100) umfasst:
eine Erfassungseinheit (110) für ein statisches Modell, die konfiguriert ist, um ein statisches Modell (22) zu erfassen;
eine Speichereinheit (120), die konfiguriert ist, um das statische Modell (22) zu speichern;
eine Ergebniserfassungseinheit (140), die konfiguriert ist, um ein Simulationsergebnis des statischen Modells (22) zu erfassen, das einen ersten stationären Zustand der Anlage anzeigt;
eine Anfangszustanderzeugungseinheit (150), die konfiguriert ist, um basierend auf dem Simulationsergebnis einen ersten Anfangswert eines Zustandsparameters eines dynamischen Modells (42) zu erzeugen, das ein Modell ist, das einen dynamischen Zustand der Anlage berechnet; und
einen dynamischen Anlagensimulator, der konfiguriert ist, um das dynamische Simulationsergebnis (44) der Anlage basierend auf dem dynamischen Modell (42) bereitzustellen,
**dadurch gekennzeichnet, dass**
die Anfangszustanderzeugungseinheit (150) ferner dazu konfiguriert ist,
eines von einer Einheit, einer physikalischen Größe und einer Variablen eines Zustandsparameterwerts von mindestens einer Vorrichtung der Anlage, die in dem statischen Modell (22) enthalten ist, in den ersten Anfangswert des Zustandsparameters von mindestens einer entsprechenden Vorrichtung der Anlage in dem dynamischen Modell (42) umzuwandeln, die jeweils der mindestens einen Vorrichtung entspricht, die in dem statischen Modell (22) enthalten ist,
wobei der Zustandsparameterwert durch eine Simulation unter Verwendung des statischen Modells (22) berechnet wird.

2. Vorrichtung nach Anspruch 1, wobei die Vorrichtung (100) ferner eine Einheit (130) zum Erzeugen eines dynamischen Modells umfasst, die konfiguriert ist, um das dynamische Modell (42) basierend auf dem statischen Modell (22) zu erzeugen.

3. Vorrichtung nach Anspruch 2, wobei
die Einheit (130) zum Erzeugen eines dynamischen Modells ferner konfiguriert ist, um das dynamische Modell (42) zu erzeugen, das umfasst:
eine Vielzahl von Vorrichtungen, die jeweils einer Vielzahl von Vorrichtungen entsprechen, die in dem statischen Modell (22) enthalten sind; und
eine Verbindungsbeziehung zwischen Vorrichtungen, die einer Verbindungsbeziehung zwischen der Vielzahl von Vorrichtungen entspricht, die in dem statischen Modell (22) enthalten sind.

4. Vorrichtung nach Anspruch 2 oder 3, wobei die Vorrichtung (100) ferner umfasst:
eine Erfassungseinheit (220) für Rohrleitungs- und Instrumentierungsdiagrammdaten, die konfiguriert ist, um Rohrleitungs- und Instrumentierungsdiagrammdaten (32) der Anlage zu erfassen; und
eine Abgleicheinheit (230), die konfiguriert ist, um eine in dem statischen Modell (22) enthaltene Vorrichtung mit einer in den Rohrleitungs- und Instrumentierungsdiagrammdaten (32) enthaltenen Vorrichtung abzugleichen, um eine Vorrichtung-zu-Vorrichtung-Entsprechungsbeziehung zu identifizieren, wobei
die Erzeugungseinheit (130) für das dynamische Modell ferner konfiguriert ist, um basierend auf einem Abgleichergebnis durch die Abgleicheinheit (230) das dynamische Modell (42) zu erzeugen.

5. Vorrichtung nach einem der Ansprüche 1 bis 4, wobei
die Ergebniserfassungseinheit (140) ferner konfiguriert ist, um das Simulationsergebnis des statischen Modells (22) für jeden einer Vielzahl von stationären Zuständen, einschließlich des ersten stationären Zustands, der Anlage zu erfassen, und
die Anfangszustanderzeugungseinheit (150) ferner konfiguriert ist, um basierend auf dem Simulationsergebnis für jeden der Vielzahl von stationären Zuständen eine Vielzahl von Anfangswerten, einschließlich des ersten Anfangswerts, des Zustandsparameters des dynamischen Modells (42) zu erzeugen.

6. Simulationssystem (200) zum Bestimmen einer Spezifikation für mindestens eines von einem Entwurf einer Anlage, von Vorrichtungen in der Anlage und einer Dimensionierung der Anlage zu bestimmen, und/oder zum Überprüfen eines dynamischen Verhaltens der Anlage, wobei das Simulationssystem (200) umfasst:
die Vorrichtung (100) nach einem der Ansprüche 1 bis 5;
einen statischen Simulator (20), der zum Durchführen einer statischen Simulation konfiguriert ist, um das statische Modell (22) zu erzeugen; und
einen dynamischen Simulator (40), der so konfiguriert ist, dass er eine dynamische Simulation ausführt, indem er den Zustandsparameter des dynamischen Modells (42) als Anfangswert einstellt und das dynamische Modell (42) verwendet.

7. System nach Anspruch 6, wobei
der dynamische Simulator (40) ferner konfiguriert ist, um den Zustandsparameter des dynamischen Modells (42) als den Anfangswert einzustellen, um eine dynamische Zustandsänderung des dynamischen Modells (42) zu simulieren, die im Ansprechen auf eine Trainingsoperation eines Bedieners auftritt.

8. Verfahren zum Erzeugen eines dynamischen Modells und eines dynamischen Simulationsergebnisses, um eine Spezifikation für mindestens eines von einem Entwurf einer Anlage, von Vorrichtungen in der Anlage und einer Dimensionierung der Anlage zu bestimmen und/oder um ein dynamisches Verhalten der Anlage zu überprüfen, wobei das Verfahren umfasst
Erfassen eines statischen Modells (22);
Speichern des statischen Modells (22);
Erfassen eines Simulationsergebnisses des statischen Modells (22), das einen stationären Zustand der Anlage anzeigt;
Erzeugen, basierend auf dem Simulationsergebnis, eines Anfangswerts eines Zustandsparameters eines dynamischen Modells (42), das ein Modell ist, das einen dynamischen Zustand der Anlage berechnet; und
Simulieren eines Zustands der Anlage basierend auf dem dynamischen Modell (42), wodurch das dynamische Simulationsergebnis bereitgestellt wird,
**dadurch gekennzeichnet, dass**
das Verfahren ferner umfasst:
Umwandeln eines von einer Einheit, einer physikalischen Größe und einer Variablen eines Zustandsparameterwerts von mindestens einer Vorrichtung der Anlage, die in dem statischen Modell (22) enthalten ist, in den Anfangswert des Zustandsparameters von mindestens einer entsprechenden Vorrichtung der Anlage in dem dynamischen Modell (42), die jeweils der mindestens einen Vorrichtung entspricht, die in dem statischen Modell (22) enthalten ist, und
wobei der Zustandsparameterwert durch eine Simulation unter Verwendung des statischen Modells (22) berechnet wird.

9. Programm, das einen Computer veranlasst, als die Vorrichtung (100) nach einem der Ansprüche 1 bis 5 zu dienen.

10. Programm, das einen Computer veranlasst, als das Simulationssystem (200) nach Anspruch 6 oder 7 zu dienen.

## Revendications

1. Appareil de génération d'un modèle dynamique et d'un résultat de simulation dynamique pour déterminer une spécification pour au moins l'un parmi une conception d'une installation, des dispositifs dans l'installation et un dimensionnement de l'installation, et/ou pour contrôler un comportement dynamique de l'installation, l'appareil (100) comprenant :
une unité d'acquisition de modèle statique (110) configurée pour acquérir un modèle statique (22) ;
une unité de stockage (120) configurée pour stocker le modèle statique (22) ;
une unité d'acquisition de résultat (140) configurée pour acquérir un résultat de simulation du modèle statique (22) indiquant un premier état stable de l'installation ;
une unité de génération d'état initial (150) configurée pour générer, sur la base du résultat de simulation, une première valeur initiale d'un paramètre d'état d'un modèle dynamique (42) qui est un modèle calculant un état dynamique de l'installation ; et
un simulateur d'installation dynamique configuré pour fournir le résultat de simulation dynamique (44) de l'installation sur la base du modèle dynamique (42),
**caractérisé en ce que**
l'unité de génération d'état initial (150) est en outre configurée
pour convertir l'une parmi une unité, une quantité physique et une variable d'une valeur de paramètre d'état d'au moins un dispositif de l'installation inclus dans le modèle statique (22) en la première valeur initiale du paramètre d'état d'au moins un dispositif correspondant de l'installation dans le modèle dynamique (42) correspondant respectivement à l'au moins un dispositif inclus dans le modèle statique (22),
la valeur de paramètre d'état étant calculée par une simulation en utilisant le modèle statique (22).

2. Appareil selon la revendication 1, l'appareil (100) comprenant en outre une unité de génération de modèle dynamique (130) configurée pour générer le modèle dynamique (42) sur la base du modèle statique (22).

3. Appareil selon la revendication 2, dans lequel
l'unité de génération de modèle dynamique (130) est en outre configurée pour générer le modèle dynamique (42) qui inclut :
une pluralité de dispositifs correspondant respectivement à une pluralité de dispositifs inclus dans le modèle statique (22) ; et
une relation de liaison entre des dispositifs correspondant à une relation de liaison entre la pluralité de dispositifs inclus dans le modèle statique (22).

4. Appareil selon la revendication 2 ou 3, l'appareil (100) comprenant en outre :
une unité d'acquisition de données de schéma de tuyauterie et d'instrumentation (220) configurée pour acquérir des données de schéma de tuyauterie et d'instrumentation (32) de l'installation ; et
une unité de mise en correspondance (230) configurée pour mettre en correspondance un dispositif inclus dans le modèle statique (22) et un dispositif inclus dans les données de schéma de tuyauterie et d'instrumentation (32) l'un avec l'autre pour identifier une relation de correspondance entre dispositifs, dans lequel
l'unité de génération de modèle dynamique (130) est en outre configurée pour générer, sur la base d'un résultat de mise en correspondance par l'unité de mise en correspondance (230), le modèle dynamique (42).

5. Appareil selon l'une quelconque des revendications 1 à 4, dans lequel
l'unité d'acquisition de résultat (140) est en outre configurée pour acquérir le résultat de simulation du modèle statique (22) pour chacun parmi une pluralité d'états stables, incluant le premier état stable, de l'installation, et
l'unité de génération d'état initial (150) est en outre configurée pour générer, sur la base du résultat de simulation pour chacun parmi la pluralité d'états stables, une pluralité de valeurs initiales, incluant la première valeur initiale, du paramètre d'état du modèle dynamique (42).

6. Système de simulation (200) pour déterminer une spécification pour au moins l'un parmi une conception d'une installation, des dispositifs dans l'installation et un dimensionnement de l'installation, et/ou pour contrôler un comportement dynamique de l'installation, le système de simulation (200) comprenant :
l'appareil d'analyse (100) selon l'une quelconque des revendications 1 à 5 ;
un simulateur statique (20) configuré pour réaliser une simulation statique pour générer le modèle statique (22) ; et
un simulateur dynamique (40) configuré pour réaliser une simulation dynamique en réglant le paramètre d'état du modèle dynamique (42) à la valeur initiale et en utilisant le modèle dynamique (42).

7. Système selon la revendication 6, dans lequel
le simulateur dynamique (40) est en outre configuré pour régler le paramètre d'état du modèle dynamique (42) à la valeur initiale pour simuler un changement d'état dynamique du modèle dynamique (42) survenant en réponse à une opération de formation d'un opérateur.

8. Procédé de génération d'un modèle dynamique et d'un résultat de simulation dynamique pour déterminer une spécification pour au moins l'un parmi une conception d'une installation, des dispositifs dans l'installation et un dimensionnement de l'installation, et/ou pour contrôler un comportement dynamique de l'installation, le procédé comprenant :
l'acquisition d'un modèle statique (22) ;
le stockage du modèle statique (22) ;
l'acquisition d'un résultat de simulation du modèle statique (22) indiquant un état stable de l'installation ;
la génération, sur la base du résultat de simulation, d'une valeur initiale d'un paramètre d'état d'un modèle dynamique (42) qui est un modèle calculant un état dynamique de l'installation ; et
la simulation d'un état de l'installation sur la base du modèle dynamique (42), en fournissant de ce fait le résultat de simulation dynamique,
**caractérisé en ce que**
le procédé comprend en outre :
la conversion de l'une parmi une unité, une quantité physique et une variable d'une valeur de paramètre d'état d'au moins un dispositif de l'installation inclus dans le modèle statique (22) en la valeur initiale du paramètre d'état d'au moins un dispositif correspondant de l'installation dans le modèle dynamique (42) correspondant respectivement à l'au moins un dispositif inclus dans le modèle statique (22), et
la valeur de paramètre d'état étant calculée par une simulation en utilisant le modèle statique (22).

9. Programme qui amène un ordinateur à servir d'appareil (100) selon l'une quelconque des revendication 1 à 5.

10. Programme qui amène un ordinateur à servir de système de simulation (200) selon la revendication 6 ou 7.
